# EUROPEAN PATENT APPLICATION

(11) **EP 2 017 295 A1**
(43) Date of publication of application: **21.01.2009**
(21) Application number: 07742383.8
(22) Date of filing: 25.04.2007
(51) Int. Cl.: C08G 59/32, C08G 77/14, C08L 83/06, H01L 21/52, H01L 23/29, H01L 23/31, H01L 33/00

(54) **THERMOSETTING COMPOSITION FOR OPTICAL SEMICONDUCTOR, DIE BOND MATERIAL FOR OPTICAL SEMICONDUCTOR DEVICE, UNDERFILL MATERIAL FOR OPTICAL SEMICONDUCTOR DEVICE, SEALING AGENT FOR OPTICAL SEMICONDUCTOR DEVICE, AND OPTICAL SEMICONDUCTOR DEVICE**

(30) Priority: 26.04.2006 JP 2006122082; 03.08.2006 JP 2006212385; 11.12.2006 JP 2006333593; 11.01.2007 JP 2007003630; 22.01.2007 JP 2007011575
(71) Applicant: Sekisui Chemical Co., Ltd., Osaka 530-8565 (JP)
(72) Inventor: TANIKAWA, Mitsuru, Mishima-gun, Osaka 618-8589 (JP); WATANABE, Takashi, Mishima-gun, Osaka 618-8589 (JP); NISHIMURA, Takashi, Mishima-gun, Osaka 618-8589 (JP)
(74) Representative: Hart-Davis, Jason
(86) International application number: PCT/JP2007/058948
(87) International publication number: WO 2007/125956

(57) **Abstract**

To provide a thermosetting composition for an optical semiconductor which is highly transparent, is free-from decrease in thickness or discoloration of a cured product due to heat generation or light emitting of a light emitting device, is superior in heat resistance and lightfastness, and has excellent adhesion to a housing material or the like, a sealing agent for an optical semiconductor device and a die bond material for an optical semiconductor device using the same, and an optical semiconductor device obtained by using the thermosetting composition for an optical semiconductor, the sealing agent for an optical semiconductor, the die bond material for an optical semiconductor device and/or the underfill material for an optical semiconductor device.

A thermosetting composition for an optical semiconductor containing a silicone resin having a cyclic ether-containing groups and a thermosetting agent capable of reacting with said cyclic ether-containing group, wherein the silicone resin has, as the principal components, a structural unit expressed by the following formula (1) and a structural unit expressed by the following formula (2), the content of the structural unit expressed by the formula (1) is 0.6 to 0.95 (on a molar basis) and the content of the structural unit expressed by the formula (2) is 0.05 to 0.4 (on a molar basis) when total number of the structural units contained is taken as 1, and the content of the cyclic ether-containing group is 5 to 40 mol%:

[formula 1] (R¹R²SiO_{2/2}) (1)

and

[formula 2] (R³SiO_{3/2}) (2)

in the formula (1) and (2), at least one of R¹, R² and R³ represents a cyclic ether-containing group, R¹, R² and R³ other than the cyclic ether-containing group represent hydrocarbon having 1 to 8 carbon atoms or fluoride thereof and they may be the same or may be different from one another and plural types of R¹, R² and R³ different from each other in a repeating unit in a silicone resin skeleton may be contained.

## Description

### TECHNICAL FIELD

The present invention relates to a thermosetting composition for an optical semiconductor which is highly transparent, is free-from decrease in thickness or discoloration of a cured product due to heat generation or light emitting of a light emitting device, is superior in heat resistance and lightfastness, and has excellent adhesion to a housing material or the like, a sealing agent for an optical semiconductor device and a die bond material for an optical semiconductor device using the same, and an optical semiconductor device obtained by using the thermosetting composition for an optical semiconductor, the sealing agent for an optical semiconductor, the die bond material for an optical semiconductor device and/or an underfill material for an optical semiconductor device.

### BACKGROUND ART

When a light emitting device of the optical semiconductor device such as a light emitting diode (LED) is exposed directly to air, its light emitting property is deteriorated rapidly due to water, dust or the like in the air, and therefore it generally has a structure sealed with a sealing agent. As a resin constituting such a sealing agent to seal the light emitting device, epoxy resins such as a bisphenol type epoxy resins and an alicyclic epoxy resin have been used (refer to Patent Document 1) because of a large adhesive force and excellent mechanical durability.

Incidentally, in recent years, LEDs are being used in applications such as the headlights of automobiles or illumination lamps where high luminance is required, and therefore high heat resistance to stand an increase in heat generation quantity at the time of lighting and high lightfastness to prevent the photo-degradation associated with higher luminance are required for the sealing agent to seal the light emitting device. However, conventional sealing agents made of an epoxy resin hardly have adequate heat resistance and lightfastness, and the sealing agent made of an epoxy resin has the problem that it cannot respond to applications such as the headlights of automobiles or illumination lamps where high luminance is required.

Further, conventional sealing agent made of an epoxy resin has advantages that adhesion is high, moisture permeability is low and the like, but has the problems that lightfastness for light of short wavelength is low and the sealing agent is colored due to photo-degradation. Further, their heat resistance is not adequate and cannot respond to heat generation of the recent light emitting device having high luminance.

On the one hand, a method of using a silicone resin as a sealing agent with which a light emitting device of an LED is sealed in place of the epoxy resin is known (e.g., refer to Patent Document 2).
However, the sealing agent made of a silicone resin has high transparency for light of a short wavelength of from blue region to ultraviolet region and is superior in heat resistance and lightfastness, but has the problems that since this sealing agent has surface tackiness, extraneous substances tend to adhere to the surface of the light emitting device and a light emitting surface is apt to suffer damage. Further, the sealing agent made of a silicone resin also has the problems of low adhesion to housing materials or the like and low reliability.
On the other hand, a silicone resin sealing agent in which a crosslinking density is enhanced has no surface tackiness and can prevent the adhesion of extraneous substances and the damage of a light emitting surface, but has the problems that the adhesion of the sealing agent to a housing material or the like in which a light emitting device is encapsulated becomes further inadequate and mechanical strength is significantly deteriorated.

Furthermore, the sealing agent made of a silicone resin has the problems that moisture permeability is high and light emitting property of a light emitting device is deteriorated through a long-term use.
Further, the sealing agent made of a silicone resin has the problems that a refractive index is low and efficiency of taking out light is not adequate in sealing a light emitting device of an optical semiconductor, and adequate performance for solving these problems could not be achieved even when the silicone resin is used in conjunction with an epoxy resin.

On the other hand, in Patent Document 3, there is proposed a sealing agent containing an epoxy modified silicone resin having a structure expressed by R⁴R¹R¹SiO_{1/2}(R¹R¹SiO_{2/2})ₓ(R¹R²SiO_{2/2})_{y}(R¹R³SiO_{2/2})_{z}OSiR¹R¹R⁴, wherein R¹ is a hydrogen group or aliphatic hydrocarbon having 1 to 6 carbon atoms, R² is an epoxy group-containing group, and R³ is an alicyclic hydrocarbon group.
However, the sealing agent containing an epoxy modified silicone resin having such a structure has high transparency for light of a short wavelength of from blue region to ultraviolet region and is superior in lightfastness, but has the problems that heat resistance is not adequate and decrease in thickness of the sealing agent is occurred if the sealing agent is exposed to a high-temperature condition. If such decrease in thickness of the sealing agent is occurred, since optical property of the light emitting device varies gradually with the decrease in thickness of the sealing agent, it is difficult to use the sealing agent for applications such as the headlights of automobiles or illumination lamps where a high level of optical properties are required.
Patent Document 1: Japanese Kokai Publication 2003-277473
Patent Document 2: Japanese Kokai Publication 2002-314142
Patent Document 3: Japanese Kokai Publication 2004-155865

### DISCLOSURE OF THE INVENTION

### PROBLEMS TO BE SOLVED BY THE INVENTION

In view of the above state of the art, it is an object of the present invention to provide a thermosetting composition for an optical semiconductor which is highly transparent, is free-from decrease in thickness or discoloration of a cured product due to heat generation or light emitting of a light emitting device, is superior in heat resistance and lightfastness, and has excellent adhesion to a housing material, a sealing agent for an optical semiconductor device, a die bond material for an optical semiconductor device, an underfill material for an optical semiconductor device, and an optical semiconductor device obtained by using the thermosetting composition for an optical semiconductor, the sealing agent for an optical semiconductor device, the die bond material for an optical semiconductor device and/or the underfill material for an optical semiconductor device.

### MEANS FOR SOLVING THE PROBLEMS

The present invention pertains to a thermosetting composition for an optical semiconductor containing a silicone resin having a cyclic ether-containing group and a thermosetting agent capable of reacting with the cyclic ether-containing group, wherein the silicone resin has, as the principal components, a structural unit expressed by the following formula (1) and a structural unit expressed by the following formula (2), the content of the structural unit expressed by the formula (1) is 0.6 to 0.95 (on a molar basis) and the content of the structural unit expressed by the formula (2) is 0.05 to 0.4 (on a molar basis) when total number of the structural units contained is taken as 1, and the content of the cyclic ether-containing group is 5 to 40 mol%.

[formula 1] (R¹R²SiO_{2/2}) (1)

and

[formula 2] (R³SiO_{3/2}) (2)

in the formulas (1) and (2), at least one of R¹, R² and R³ represents a cyclic ether-containing group, R¹, R² and R³ other than the cyclic ether-containing group represent hydrocarbon having 1 to 8 carbon atoms or fluoride thereof and they may be the same or may be different from one another. In addition, plural types of R¹, R² and R³ different from each other in a repeating unit in a silicone resin skeleton may be contained.
Hereinafter, the present invention will be described in detail.

The present inventors made intensive investigations, and consequently have found that a sealing agent containing a silicone resin of a specific structure, which has a cyclic ether-containing group, and a thermosetting agent capable of reacting with the cyclic ether-containing group has high transparency for light of a short wavelength of from blue region to ultraviolet region, is free-from decrease in thickness or discoloration of a cured product due to heat generation or light emitting of a light emitting device to be sealed, and is superior in heat resistance and lightfastness, and this sealing agent has excellent adhesion to a housing material or the like in which a light emitting device is encapsulated when the sealing agent is used as a sealing agent to seal a light emitting device of an optical semiconductor device such as a light emitting diode. These findings have now led to completion of the present invention.

The thermosetting composition for an optical semiconductor of the present invention contains a silicone resin having a cyclic ether-containing group.
In the thermosetting composition for an optical semiconductor of the present invention, the silicone resin has a structural unit expressed by the formula (1) and a structural unit expressed by the formula (2) as the principal components. In the present description, the term "have as the principal components" means that the silicone resin is preferably composed of only the structural unit expressed by the formula (1) and the structural unit expressed by the formula (2), but it may have other structural units other than the structural unit expressed by the formula (1) and the structural unit expressed by the formula (2) within the scope which does not impair an effect of the present invention.

In the silicone resin, a content of the structural unit expressed by the formula (1) has a lower limit of 0.6 and an upper limit of 0.95 (on a molar basis) and a content of the structural unit expressed by the formula (2) has a lower limit of 0.05 and an upper limit of 0.4 (on a molar basis) when total number of the structural units contained is taken as 1. By containing a silicone resin having a cyclic ether-containing group and including the structural unit expressed by the formula (1) and the structural unit expressed by the formula (2) within the range, the thermosetting composition for an optical semiconductor of the present invention has high transparency for light of a short wavelength of from blue region to ultraviolet region, is free-from decrease in thickness or discoloration of the cured product due to heat generation or light emitting of a light emitting device to be sealed and is superior in heat resistance and lightfastness when being used as a sealing agent of an optical semiconductor device, and has excellent adhesion to a housing material or the like of the optical semiconductor device when a light emitting device of the optical semiconductor device such as a light emitting diode is sealed with this thermosetting composition.

In the structural unit expressed by the formula (1) and the structural unit expressed by the formula (2), at least one of R¹, R² and R³ represents a cyclic ether-containing group. In the present description, the cyclic ether-containing group may be a group including a cyclic ether group in at least a part of the group and it means a group which may contain another skeleton such as an alkyl group or an alkyl ether group and the cyclic ether group.
The cyclic ether-containing group is not particularly limited, and examples of the cyclic ether-containing group include such as a glycidyl group, an epoxycyclohexyl group, and an oxetane group. Among them, the glycidyl group and/or the epoxycyclohexyl group is suitable.
Further, the silicone resin may contain plural types of R¹, R² and R³ different from each other in a repeating unit in a silicone resin skeleton. This means that the silicone resin may contain both the structural unit expressed by the formula (1) and the structural unit expressed by the formula (2) in its skeleton as an essential component and a plurality of the structural units repeated may not be necessarily the same repeating unit.

The glycidyl group is not particularly limited, and examples of the glycidyl group include such as a 2, 3-epoxypropyl group, a 3,4-epoxybutyl group, a 4,5-epoxypentyl group, a 2-glycidoxyethyl group, a 3-glycidoxypropyl group, and a 4-glycidoxybutyl group.

The epoxycyclohexyl group is not particularly limited, and examples of the epoxycyclohexyl group include such as a 2-(3,4-epoxycyclohexyl)ethyl group and a 3-(3,4-epoxycyclohexyl)propyl group.

In the silicone resin, a content of the cyclic ether-containing group has a lower limit of 5 mol% and an upper limit of 40 mol%. When the content is less than 5 mol%, the reactivity of the silicone resin with a thermosetting agent described later is significantly lowered, and a curing property of the thermosetting composition for an optical semiconductor of the present invention becomes insufficient. When the content is more than 40 mol%, a cyclic ether-containing group, which is not involved in a reaction of the silicone resin with the thermosetting agent, increases and the heat resistance of the thermosetting composition for an optical semiconductor of the present invention is lowered. A preferable lower limit is 7 mol% and a preferable upper limit is 30 mol%.
Here, in the present description, the content of the cyclic ether-containing group refers to an amount of the cyclic ether-containing group contained in an average composition of the components of the silicone resin.

In the structural unit expressed by the formula (1) and the structural unit expressed by the formula (2), R¹, R² and R³ other than the cyclic ether-containing group represent hydrocarbon having 1 to 8 carbon atoms or fluoride thereof.

The hydrocarbon having 1 to 8 carbon atoms is not particularly limited, and examples of the hydrocarbon include such as a methyl group, an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group, and a phenyl group.

In the silicone resin, the structural unit (hereinafter, also referred to as a bifunctional structural unit) expressed by the formula (1) includes a structure expressed by the following formula (1-2), that is, a structure in which one of oxygen atoms coupled with a silicon atom in the bifunctional structural unit constitutes a hydroxyl group or an alkoxy group.

(R¹R²SiXO_{1/2}) (1-2)

In the formula (1-2), X represents OH or OR, and the OR represents a linear or branched alkoxy group having 1 to 4 carbon atoms.

Further, in the silicone resin, the structural unit (hereinafter, also referred to as a trifunctional structural unit) expressed by the formula (2) includes a structure expressed by the following formula (2-2) or (2-3), that is, a structure in which two of oxygen atoms coupled with a silicon atom in the trifunctional structural unit respectively constitute a hydroxyl group or an alkoxy group, or one of oxygen atoms coupled with a silicon atom in the trifunctional structural unit constitutes a hydroxyl group or an alkoxy group.

(R³SiX₂O_{1/2}) (2-2)

(R³SiXO_{2/2}) (2-3)

In the formulas (2-2) and (2-3), X represents OH or OR, and the OR represents a linear or branched alkoxy group having 1 to 4 carbon atoms.

In the formulas (1-2), (2-2) and (2-3), the linear or branched alkoxy group having 1 to 4 carbon atoms is not particularly limited, and examples of the alkoxy group include a methoxy group, an ethoxy group, a n-propoxy group, a n-butoxy group, an isopropoxy group, an isobutoxy group, a sec-butoxy group, and a t-butoxy group.

When 29Si nuclear magnetic resonance (hereinafter, NMR) analysis of the silicone resin is performed by use of tetramethylsilane (hereinafter, TMS) as a reference, each peak corresponding to the bifunctional structural units of the formulas (1) and (1-2) appears in the vicinity of -10 to -30 ppm, and each peak corresponding to the trifunctional structural units of the formulas (2), (2-2) and (2-3) appears in the vicinity of -50 to -70 ppm, though there are fluctuations slightly depending on some kinds of substituents.
Accordingly, a ratio in the silicone resins can be measured by measuring 29Si NMR and comparing peak areas of each signal.
However, such as when a bifunctional structural unit of the formula (1) cannot be distinguished by a 29Si NMR analysis using tetramethylsilane (TMS) as a reference, a ratio between the structural units can be identified by using not only the results of the 29Si NMR measurement but also the results of measurements of such as 1H NMR or 19F NMR as required.

In the silicone resin having such a difunctional structural unit and a trifunctional structural unit as principal components, an average composition formula is preferably expressed by the following formula (3), (4) or (5) . Here, "the average composition formula of the silicone resin is expressed by the following formula (3), (4) or (5)" means not only the case where the thermosetting composition for an optical semiconductor of the present invention contains only a resin component expressed by the following formula (3), (4) or (5) as a silicone resin but also the case where the thermosetting composition for an optical semiconductor of the present invention is a mixture containing resin components of various structures and averaged composition of the contained resin components is expressed by the following formula (3), (4) or (5) .

[formula 3] (R⁴R⁵SiO_{2/2})ₐ(R⁶SiO_{3/2})_{b} (3)

In the formula (3), a and b satisfy the equations a/ (a+b)=0.6 to 0.95 and b/ (a+b)=0.05 to 0.4, any one of R⁴ to R⁶ is a cyclic ether-containing group, R⁴ to R⁶ other than the cyclic ether-containing group are hydrocarbon having 1 to 8 carbon atoms or fluoride thereof and they may be the same or may be different from one another.

[formula 4] (R⁷R⁸SiO_{2/2})_{c}(R⁹R¹⁰SiO_{2/2})_{d}(R¹¹SiO_{3/2})ₑ (4)

In the formula (4), c, d and e satisfy the equations (c+d)/(c+d+e)=0.6 to 0.95 and e/(c+d+e)=0.05 to 0.4, any one of R⁷ to R¹¹ is a cyclic ether-containing group, R⁷ to R¹¹ other than the cyclic ether-containing group are hydrocarbon having 1 to 8 carbon atoms or fluoride thereof and they may be the same or may be different from one another. However, (R⁷R⁸SiO_{2/2}) is different in a structure from (R⁹R¹¹SiO_{2/2}).

[formula 5] (R¹²R¹³SiO_{2/2})_{f}(R¹⁴SiO_{3/2})_{g}(R¹⁵SiO_{3/2})ₕ (5)

In the formula (5), f, g and h satisfy the equations f/(f+g+h)=0.6 to 0.95 and (g+h) / (f+g+h)=0.05 to 0.4, any one of R¹² to R¹⁵ is a cyclic ether-containing group, R¹² to R¹⁵ other than the cyclic ether-containing group are hydrocarbon having 1 to 8 carbon atoms or fluoride thereof and they may be the same or may be different from one another. However, (R¹⁴SiO_{3/2}) is different in a structure from (R¹⁵SiO_{3/2}).

In the thermosetting composition for an optical semiconductor of the present invention, in the silicone resin, it is preferable that the cyclic ether-containing group is coupled with a polysiloxane skeleton via a silicon-carbon bond. By coupling the cyclic ether-containing group with the polysiloxane skeleton via a silicon-carbon bond, the thermosetting composition for an optical semiconductor of the present invention becomes superior in heat resistance, lightfastness and decrease in thickness of the cured product and it is preferable. For example, when a resin obtained by an addition reaction by which an OH group is reacted is used, since the cyclic ether-containing group is coupled with the polysiloxane skeleton via a silicon-oxygen bond, in such a silicone resin, there may be not only the case where adequate heat resistance and lightfastness are not attained but also the case where the decrease in thickness of the cured product is accelerated.

Further, the silicone resin preferably has a cyclic ether-containing group in the structural unit expressed by the formula (2), namely, the trifunctional structural unit. When the cyclic ether-containing group is contained in the trifunctional structural body, the cyclic ether-containing group can easily go out of the polysiloxane skeleton of the silicone resin, and the cured product of the thermosetting composition for an optical semiconductor of the present invention forms an adequate three-dimensional crosslinked structure and its heat resistance becomes adequate and this can suitably prevent the decrease in thickness from being produced in the cured product.

As the silicone resin, the cyclic ether-containing group of which is coupled with the trifunctional structural unit, specifically, a resin in which an average composition formula is expressed by the following formula (6), (7) or (8) is preferable.

[formula 6] (R¹⁶R¹⁷SiO_{2/2})ᵢ(R¹⁸SiO_{3/2})ⱼ (6)

In the formula (6), i and j satisfy the equations i/(i+j)=0.6 to 0.95 and j/(i+j)=0.05 to 0.4, R¹⁸ is a cyclic ether-containing group, R¹⁶ and R¹⁷ are hydrocarbon having 1 to 8 carbon atoms or fluoride thereof and they may be the same or may be different from each other.

[formula 7] (R¹⁹R²⁰SiO_{2/2})ₖ(R²¹ R²²SiO_{2/2})ₗ(R²³SiO_{3/2})ₘ (7)

In the formula (7), k, 1 and m satisfy the equations (k+l)/(k+l+m)=0.6 to 0.95 and m/(k+l+m)=0.05 to 0.4, R²³ is a cyclic ether-containing group, R¹⁹ to R²² are hydrocarbon having 1 to 8 carbon atoms or fluoride thereof and they may be the same or may be different from one another. However, (R¹⁹R²⁰SiO_{2/2}) is different in a structure from (R²¹R²²SiO_{2/2}).

[formula 8] (R²⁴R²⁵SiO_{2/2})ₙ(R²⁶SiO_{3/2})ₒ(R²⁷SiO_{3/2})ₚ (8)

In the formula (8), n, o and p satisfy the equations n/(n+o+p)=0.6 to 0.95 and (o+p)/(n+o+p)=0.05 to 0.4, R²⁶ is a cyclic ether-containing group, R²⁴, R²⁵ and R²⁷ are hydrocarbon having 1 to 8 carbon atoms or fluoride thereof and they may be the same or may be different from one another.

The silicone resin may have a structural unit other than these structural units as long as it has a structural unit expressed by the formula (1) and a structural unit expressed by the formula (2) as the principal components. In this case, when total number of the structural units contained in the silicone resin is taken as 1, a total content of the structural unit expressed by the formula (1) and the structural unit expressed by the formula (2) preferably has a lower limit of 0.9 (on a molar basis). When the total content is less than 0.9 (on a molar basis), excellent effects such as heat resistance, lightfastness and high adhesion of the thermosetting composition for an optical semiconductor of the present invention may be significantly impaired. More preferable lower limit is 0.95 (on a molar basis).

The structural unit other than the structural unit expressed by the formula (1) and the structural unit expressed by the formula (2) which may be contained in the silicone resin is not particularly limited, and a structural unit expressed by the following formula (9) or formula (10) is included as an example.

[formula 9] (R²⁸R²⁹R³⁰SiO_{1/2}) (9)

In the formula (9), R²⁸, R²⁹ and R³⁰ represent a cyclic ether-containing group, or hydrocarbon having 1 to 8 carbon atoms or fluoride thereof, and they may be the same or may be different from one another.

[formula 10] (SiO_{4/2}) (10)

When the silicone resin contains the structural unit expressed by the formula (9) or the formula (10), the content of these structural units is not particularly limited as long as the total content of the structural unit expressed by the formula (1) and the structural unit expressed by the formula (2) falls within the above range, and, for example, a content of the structural unit expressed by the formula (9) preferably has an upper limit of 0.1 1 (on a molar basis) when total number of the structural units contained in the silicone resin is taken as 1. A content of the structural unit expressed by the formula (10) preferably has an upper limit of 0.1 (on a molar basis). When the content of the structural unit expressed by the formula (9) exceeds 0.1 (on a molar basis), the heat resistance of the thermosetting composition for an optical semiconductor of the present invention may be deteriorated. Further, if the content of the structural unit expressed by the formula (10) exceeds 0.1, it may become difficult to retain proper viscosity or adhesion of the thermosetting composition for an optical semiconductor of the present invention.

Here, the structural unit (hereinafter, also referred to as a tetrafunctional structural unit) expressed by the formula (9) includes a structure expressed by the following formula (9-2), (9-3) or (9-4), that is, a structure in which three or two of oxygen atoms coupled with a silicon atom in the tetrafunctional structural unit constitute a hydroxyl group or an alkoxy group, or one of oxygen atoms coupled with a silicon atom in the tetrafunctional structural unit constitutes a hydroxyl group or an alkoxy group.

(SiX₃O_{1/2}) (9-2)

(SiX₂O_{2/2}) (9-3)

(SiXO_{3/2}) (9-4)

In the formula (9-2), (9-3) or (9-4), X represents OH or OR, and the OR represents a linear or branched alkoxy group having 1 to 4 carbon atoms.

In the formulas (9-2) to (9-4), the linear or branched alkoxy group having 1 to 4 carbon atoms is not particularly limited, and examples of the alkoxy group include such as a methoxy group, an ethoxy group, a n-propoxy group, a n-butoxy group, an isopropoxy group, an isobutoxy group, a sec-butoxy group, and a t-butoxy group.

In the thermosetting composition for an optical semiconductor of the present invention, the silicone resin preferably contains the alkoxy group within the range in which a lower limit is 0.5 mol% and an upper limit is 10 mol%. By containing such an alkoxy group, the heat resistance and the lightfastness of the cured product of the thermosetting composition for an optical semiconductor of the present invention are outstandingly improved. The reason is considered that since the silicone resin contains the alkoxy group and thereby a curing rate can be outstandingly improved, heat deterioration at the time of curing can be prevented.
Further, as described above, the outstanding improvement in the curing rate enables to attain adequate curing property even in a relatively small amount in adding a curing accelerator.

When the content of the alkoxy group is less than 0.5 mol%, an adequate curing rate may not be attained and therefore heat resistance may be deteriorated, and when the content is more than 10 mol%, the storage stability or the heat resistance of the silicone resin or the thermosetting composition for an optical semiconductor of the present invention may be deteriorated. A more preferable lower limit of the content is 1 mol% and a more preferable upper limit is 5 mol%.
Here, in the present description, the content of the alkoxy group refers to an amount of the alkoxy group contained in the average composition of the silicone resin.

Further, the silicone resin preferably does not contain a silanol group. The silanol group is not preferable since it significantly degrades the storage stability of a polymer and in addition the storage stability at the time when the silanol group is used as a resin composition is significantly deteriorated. Such a silanol group can be decreased by heating under vacuum and an amount of the silanol group can be measured by such as an infrared spectroscopy.

In the thermosetting composition for an optical semiconductor of the present invention, a preferable lower limit of the number average molecular weight (Mn) of the silicone resin is 1000 and a preferable upper limit is 50000. When the number average molecular weight is less than 1000, it is not preferable since a volatile component increases at the time of thermal curing and a decrease in thickness of the cured product is accelerated when using as a sealing agent. When the number average molecular weight is more than 50000, it is not preferable since the control of viscosity becomes difficult. Amore preferable lower limit is 1500 and a more preferable upper limit is 15000.
Here, in the present description, the number average molecular weight (Mn) is a value measured using gel permeation chromatography (GPC) in which polystyrene is taken as a standard, and refers to a value measured by use of a measuring apparatus (column: Shodex GPC LF-804(length 300 mmx2) manufactured by Showa Denko K.K, measuring temperature: 40°C, flow rate: 1 mL/min, solvent: tetrahydrofuran, standard sample: polystyrene) manufactured by Waters Corporation.

A method of synthesizing the silicone resin is not particularly limited, and examples of the method include such as (1) a method of introducing a substituent by a hydrosilylation reaction of a silicone resin (a) having a SiH group with a vinyl compound having the cyclic ether-containing group, and (2) a method of condensation-reacting an alkoxysilane compound with an alkoxysilane compound having the cyclic ether-containing group.

In the method (1), the hydrosilylation reaction is a method of reacting a SiH group with a vinyl group in the presence of a catalyst as required.

Examples of the silicone resin (a) having a SiH group include those having a SiH group in a molecule, and including a structure having the structural unit expressed by the formula (1) and the structural unit expressed by the formula (2) as principal components, preferably a structure, a average composition formula of which is expressed by any one of the formulas (6) to (8), after the reaction with the vinyl compound having an alicyclic epoxy-containing group.

The vinyl compound having the cyclic ether-containing group is not particularly limited as long as it is a vinyl compound having one or more cyclic ether-containing groups in a molecule, and examples of the vinyl compound having the cyclic ether-containing group include such as vinyl diglycidyl ether, allyl glycidyl ether, glycidyl (meth)acrylate, butadiene monoxide, vinyl cyclohexeneoxide, and allyl cyclohexeneoxide. Here, the (meth)acryl means acryl or methacryl.

Examples of a catalyst used as required in the hydrosilylation reaction include such as single bodies of metals of group-VIII in a periodic table, these solid metals supported by a carrier such as alumina, silica, carbon black or the like, salts and complexes of the metals. As the metals of group-VIII in a periodic table, specifically, for example, platinum, rhodium, and ruthenium are suitable and platinum is particularly preferable.
Examples of the hydrosilylation reaction catalysts using the platinum include such as chloroplatinic acid, complexes of chloroplatinic acid and alcohol, aldehyde or ketone, a platinum-vinylsiloxane complex, a platinum-phosphine complex, a platinum-phosphite complex, and dicarbonyl dichloro platinum.

Reaction conditions in the hydrosilylation reaction is not particularly limited, but a reaction temperature preferably has a lower limit of 10°C and an upper limit of 200°C in consideration of a reaction rate and a yield. Amore preferable lower limit is 30°C and a more preferable upper limit is 150°C, and a furthermore preferable lower limit is 50°C and a furthermore preferable upper limit is 120°C.

Further, the hydrosilylation reaction may be performed without using a solvent, or may be performed using a solvent.
The solvent is not particularly limited, and examples of the solvent include ether type solvents such as dioxane, tetrahydrofuran, and propyleneglycol monomethyl ether acetate; ketone type solvents such as methyl ethyl ketone and methyl isobutyl ketone; hydrocarbon type solvents such as toluene, xylene, and cyclohexane; ester type solvents such as ethyl acetate and butyl acetate; alcohol type solvents such as butyl cellosolve and butyl carbitol and the like. Among them, ether type solvents, ester type solvents, ketone type solvents and hydrocarbon type solvents are preferable, and specifically, dioxane, methyl isobutyl ketone, toluene, xylene, and butyl acetate are particularly preferable from the viewpoint of solubility of raw materials and solvent recovery property.

In the method (2), examples of the alkoxysilane compound include alkoxysilane having a siloxane unit of the following formulas (11) and (12), or products of partial hydrolysis thereof.

[formula 11] R³¹R³²Si(OR)₂ (11)

[formula 12] R³³Si(OR)₃ (12)

In the formulas (11) and (12), R³¹ to R³³ represent hydrocarbon having 1 to 8 carbon atoms or fluoride thereof, and OR represents a linear or branched alkoxy group having 1 to 4 carbon atoms.

In the formulas (11) and (12), when R³¹ to R³³ represent hydrocarbon having 1 to 8 carbon atoms, specific examples of the hydrocarbon include such as a methyl group, an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group, and a phenyl group.

Further, in the formulas (11) and (12), specific examples of the linear or branched alkoxy group having 1 to 4 carbon atoms, represented by OR, include such as a methoxy group, an ethoxy group, a n-propoxy group, a n-butoxy group, an isopropoxy group, an isobutoxy group, a sec-butoxy group, and a t-butoxy group.

Specific examples of those expressed by the formula (11) include such as dimethyldimethoxysilane, dimethyldiethoxysilane, diphenyldimethoxysilane, diphenyldiethoxysilane, isopropyl(methyl)dimethoxysilane, cyclohexyl(methyl)dimethoxysilane, and methyl(phenyl)dimethoxysilane.

Specific examples of those expressed by the formula (12) include such as methyltrimethoxysilane, methyltriethoxysilane, ethyltrimethoxysilane, ethyltriethoxysilane, hexyltrimethoxysilane, octyltrimethoxysilane, and phenyltrimethoxysilane.

In the alkoxysilane compound, a mixing ratio of alkoxysilane having a siloxane unit expressed by the formulas (11) and (12) or products of partial hydrolysis thereof is appropriately adjusted such that a silicone resin, which is synthesized by condensation-reacting the alkoxysilane compound with an alkoxysilane compound having the cyclic ether-containing group as described later, includes a structure having the structural unit expressed by the formula (1) and the structural unit expressed by the formula (2), preferably a structure expressed by any one of the formulas (6) to (8).

Examples of the alkoxysilane compound having the cyclic ether-containing group include alkoxysilane having the cyclic ether-containing group, expressed by the following formulas (13) and (14) and products of partial hydrolysis thereof.

[formula 13] R³⁴R³⁵Si(OR)₂ (13)

[formula 14] R³⁶Si(OR)₃ (14)

In the formulas (13) and (14), R³⁴ and/or R³⁵, and R³⁶ are a cyclic ether-containing group, and when only one of R³⁴ and R³⁵ is a cyclic ether-containing group, the other represents hydrocarbon having 1 to 8 carbon atoms or fluoride thereof, and OR represents a linear or branched alkoxy group having 1 to 4 carbon atoms.

In the formulas (13) and (14), the cyclic ether-containing group represented by R³⁴ and/or R³⁵, and R³⁶ is not particularly limited, and examples of the cyclic ether-containing group include such as a glycidyl group, an epoxycyclohexyl group, and an oxetane group. Among them, the glycidyl group and/or the epoxycyclohexyl group is suitable.

The glycidyl group is not particularly limited, and examples of the glycidyl group include such as a 2, 3-epoxypropyl group, a 3,4-epoxybutyl group, a 4,5-epoxypentyl group, a 2-glycidoxyethyl group, a 3-glycidoxypropyl group, and a 4-glycidoxybutyl group.

The epoxycyclohexyl group is not particularly limited, and examples of the epoxycyclohexyl group include such as a 2-(3,4-epoxycyclohexyl) ethyl group and a 3-(3,4-epoxycyclohexyl) propyl group.

In the formula (13), when either R³⁴ or R³⁵ is hydrocarbon having 1 to 8 carbon atoms, specific examples of the hydrocarbon include such as a methyl group, an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group, and a phenyl group.

Further, in the formulas (13) and (14), specific examples of the linear or branched alkoxy group having 1 to 4 carbon atoms, represented by OR, include such as a methoxy group, an ethoxy group, a n-propoxy group, a n-butoxy group, an isopropoxy group, an isobutoxy group, a sec-butoxy group, and a t-butoxy group.

Specific examples of those expressed by the formula (13) include such as 3-glycidoxypropyl (methyl)dimethoxysilane, 3-glycidoxypropyl (methyl)diethoxysilane, 3-glycidoxypropyl (methyl)dibutoxysilane, 2,3-epoxypropyl (methyl)dimethoxysilane, 2-(3,4-epoxycyclohexyl)ethyl(methyl)dimethoxysilane, and 2-(3,4-epoxycyclohexyl)ethyl(methyl)diethoxysilane.

Specific examples of those expressed by the formula (14) include such as 3-glycidoxypropyl trimethoxysilane, 3-glycidoxypropyl triethoxysilane, 2-(3,4-epoxycyclohexyl)ethyl trimethoxysilane, and 2-(3,4-epoxycyclohexyl)ethyl triethoxysilane.

In the method (2), examples of a specific method of condensation-reacting the alkoxysilane compound with the alkoxysilane compound having the cyclic ether-containing group include a method of reacting the alkoxysilane compound with the alkoxysilane compound having the cyclic ether-containing group in the presence of water, and an acidic or a basic catalyst to synthesize a silicone resin.
Further, a method, in which the alkoxysilane compound is reacted in advance in the presence of water, and an acidic or a basic catalyst and then the alkoxysilane compound having the cyclic ether-containing group is reacted, may be employed.

In the method (2), when the alkoxysilane compound is reacted with the alkoxysilane compound having the cyclic ether-containing group in the presence of water, and an acidic or a basic catalyst, the alkoxysilane compound having the cyclic ether-containing group is mixed such that an amount of the cyclic ether-containing group contained in an average composition of the components of the silicone resin, synthesized by condensation-reacting the alkoxysilane compound with the alkoxysilane compound having the cyclic ether-containing group, has a lower limit of 5 mol% and an upper limit of 40 mol%.

An amount of the water to be blended is not particularly limited as long as it is capable of hydrolyzing an alkoxy group coupled with a silicon atom in the alkoxysilane compound having the cyclic ether-containing group, and the amount is appropriately adjusted.

The acidic catalyst is a catalyst for reacting the alkoxysilane compound with the alkoxysilane compound having the cyclic ether-containing group, and examples of the acidic catalyst include inorganic acids such as phosphoric acid, boric acid and carbonic acid; organic acids such as formic acid, acetic acid, propionic acid, butyric acid, lactic acid, malic acid, tartaric acid, citric acid, oxalic acid, malonic acid, succinic acid, glutaric acid, adipic acid, fumaric acid, maleic acid and oleic acid; anhydrides or derivatives thereof.

The basic catalyst is a catalyst for reacting the alkoxysilane compound with the alkoxysilane compound having the cyclic ether-containing group, and examples of the basic catalyst include hydroxides of alkali metal such as sodium hydroxide, potassium hydroxide and cesium hydroxide; alkoxides of alkali metal such as sodium t-butoxide, potassium t-butoxide and cesium t-butoxide; silanol compounds of alkali metal such as sodium silanolate compound, potassium silanolate compound and cesium silanolate compound. Among them, potassium type catalysts and cesium type catalyst are suitable.

An amount of the acidic catalyst or the basic catalyst added is not particularly limited, but the amount preferably has a lower limit of 10 ppm and an upper limit of 10000 ppm, and a more preferable lower limit is 100 ppm and a more preferable upper limit is 5000 ppm with respect to the total amount of the alkoxysilane compound and the alkoxysilane compound having the cyclic ether-containing group.
Here, as for the addition of the acidic catalyst or the basic catalyst, solid matter may be added as it is, or the acidic catalyst or the basic catalyst may be dissolved in water or the alkoxysilane compound and the like and the resulting solution may be added.

The condensation-reaction of the alkoxysilane compound with the alkoxysilane compound having the cyclic ether-containing group may be performed without using a solvent, or may be performed using a solvent.
Examples of the organic solvent include aromatic type organic solvents such as toluene and xylene; ketone type organic solvents such as acetone and methyl isobutyl ketone; aliphatic type organic solvents such as hexane, heptane, and octane, and the like. Among them, aromatic type organic solvents are suitably used.

A reaction temperature in the condensation-reaction is not particularly limited, but it preferably has a lower limit of 40°C and an upper limit of 200°C, and more preferably has a lower limit of 50°C and an upper limit of 150°C. Further, when the organic solvent is used, the condensation-reaction can be readily performed at a reflux temperature by employing a solvent having a boiling point in a range of 40 to 200°C as the organic solvent.

As a method of synthesizing the silicone resin, the method (2) is preferable from the viewpoint of controlling an amount of the alkoxy group.
In the method (2), it is possible to maintain the alkoxy group in a proper range by adjusting a reaction temperature, a reaction time, and an amount of catalyst or water.

The thermosetting composition for an optical semiconductor of the present invention preferably contains a bifunctional silicone resin having one or more glycidyl-containing groups in a molecule.
By mixing such a bifunctional silicone resin, the thermosetting composition for an optical semiconductor of the present invention significantly improves the crack resistance of the cured product. The reason is considered that the bifunctional silicone resin having a more flexible skeleton than the silicone resin penetrates into a gap between crosslinking points produced by a reaction of the cyclic ether-containing group of the silicone resin having a cyclic ether-containing group in a molecule in the cured product.

In the present description, the glycidyl-containing group may be a group including a glycidyl group in at least a part of the group and it means a group which may contain another skeleton such as an alkyl group or an alkyl ether group and the glycidyl group.
The glycidyl-containing group is not particularly limited, and examples of the glycidyl-containing group include such as a 2,3-epoxypropyl group, a 3,4-epoxybutyl group, a 4,5-epoxypentyl group, a 2-glycidoxyethyl group, a 3-glycidoxypropyl group, and a 4-glycidoxybutyl group.

The bifunctional silicone resin having such one or more glycidyl-containing groups in a molecule is not particularly limited, but it preferably contains a resin component, an average composition formula of which is expressed by the following formula (15) or (16). By the fact that the bifunctional silicone resin contains a resin component expressed by the following formula (15) or (16), the thermosetting composition for an optical semiconductor of the present invention becomes extremely excellent in crack resistance because the cured product comes to have moderate flexibility.
Here, "the average composition formula of the bifunctional silicone resin is expressed by the following formula (15) or (16)" means not only the case where the thermosetting composition for an optical semiconductor of the present invention contains only a resin component expressed by the following formula (15) or (16) as a bifunctional silicone resin but also the case where the thermosetting composition for an optical semiconductor of the present invention is a mixture containing resin components of various structures and averaged composition of the contained resin components is expressed by the following formula (15) or (16).

[formula 15] (R³⁷R³⁸SiO_{2/2})ᵣ(R³⁹R⁴⁰SiO_{2/2})ₛ (15)

In the formula (15), R³⁹ and/or R⁴⁰ is a glycidyl-containing group, and R³⁷ and R³⁸ represent hydrocarbon having 1 to 8 carbon atoms or fluoride thereof, and they may be the same or may be different from each other. Further, when only one of R³⁹ and R⁴⁰ is a glycidyl-containing group, the other represents hydrocarbon having 1 to 8 carbon atoms or fluoride thereof. Further, a preferable lower limit of r/ (r+s) is 0.6 and a preferable upper limit is 0. 95, and a more preferable lower limit is 0.7 and a more preferable upper limit is 0.9, and a preferable lower limit of s/ (r+s) is 0.05 and a preferable upper limit is 0.4, and a more preferable lower limit is 0.1 and a more preferable upper limit is 0.3.

[formula 16] (R⁴¹R⁴²SiO_{2/2})ₜ(R⁴³R⁴⁴SiO_{2/2})ᵤ(R⁴⁵R⁴⁶SiO_{2/2})ᵥ (16)

In the formula (16), R⁴⁵ and/or R⁴⁶ is a glycidyl-containing group, and R⁴¹, R⁴², R⁹³ and R⁴⁴ represent hydrocarbon having 1 to 8 carbon atoms or fluoride thereof, and they may be the same or may be different from one another. Further, when only one of R⁴⁵ and R⁴⁶ is a glycidyl-containing group, the other represents hydrocarbon having 1 to 8 carbon atoms or fluoride thereof. Further, a preferable lower limit of t+u/ (t+u+v) is 0.6 and a preferable upper limit is 0.95, and a more preferable lower limit is 0.7 and a more preferable upper limit is 0.9, and a preferable lower limit of v/ (t+u+v) is 0.05 and a preferable upper limit is 0.4, and a more preferable lower limit is 0.1 and a more preferable upper limit is 0.3.

A preferable lower limit of the number average molecular weight (Mn) of the bifunctional silicone resin is 1500 and a preferable upper limit is 50000. When the number average molecular weight is less than 1500, the crack resistance of the cured product of the thermosetting composition for an optical semiconductor of the present invention may become inadequate, and when the number average molecular weight is more than 50000, the control of viscosity of the thermosetting composition for an optical semiconductor of the present invention may become difficult. A more preferable lower limit is 2000 and a more preferable upper limit is 20000.

A method of synthesizing such a bifunctional silicone resin is not particularly limited, and examples of the method include methods similar to the methods of synthesizing a silicone resin described above, that is, a method (method (3)) of introducing a substituent by a hydrosilylation reaction of a silicone resin (b) having a SiH group with a vinyl compound having the glycidyl-containing group, a method (method (4)) of condensation-reacting an alkoxysilane compound with an alkoxysilane compound having the glycidyl-containing group and the like.

When the bifunctional silicone resin is synthesized by the method (3), examples of the silicone resin (b) having a SiH group include those having a SiH group in a molecule and including a structure expressed by the formula (15) or (16) described above after the reaction with the vinyl compound having a glycidyl-containing group.

The vinyl compound having the glycidyl-containing group is not particularly limited as long as it is a vinyl compound having one or more glycidyl-containing groups in a molecule, and examples of the vinyl compound having the glycidyl-containing group include such as vinyl glycidyl ether, allyl glycidyl ether, glycidyl (meth)acrylate, and butadiene monoxide. Here, the (meth)acryl means acryl or methacryl.

Further, in the hydrosilylation reaction, as with synthesizing the silicone resin described above, a catalyst may be used as required, and the reaction may be performed without using a solvent, or may be performed using a solvent.

When the bifunctional silicone resin is synthesized by the method (4), the alkoxysilane compound is not particularly limited, and examples of the alkoxysilane compound include those similar to the dialkoxysilane compound of the formula (11) described above.
Further, examples of the alkoxysilane compound having the glycidyl-containing group include those similar to the dialkoxysilane compound of the formula (13) described above.

Specific examples of the dialkoxysilane having the glycidyl-containing group include such as 3-glycidoxypropyl (methyl)dimethoxysilane, 3-glycidoxypropyl (methyl)diethoxysilane, 3-glycidoxypropyl (methyl)dibutoxysilane, and 2,3-epoxypropyl (methyl)dimethoxysilane.

Specific examples of the method of condensation-reacting an alkoxysilane compound with an alkoxysilane compound having the glycidyl-containing group include a method similar to the method of reacting an alkoxysilane compound with an alkoxysilane compound having the cyclic ether-containing group in the case of synthesizing the silicone resin described above.

In the thermosetting composition for an optical semiconductor of the present invention, an amount of the bifunctional silicone resin to be blended with respect to the silicone resin described above is not particularly limited, but the amount preferably has a lower limit of 10 parts by weight and an upper limit of 120 parts by weight with respect to 100 parts by weight of the silicone resin. When the amount is less than 10 parts by weight, the crack resistance of the cured product of the thermosetting composition for an optical semiconductor of the present invention may not be adequately exhibited and when the amount is more than 120 parts by weight, the cured product of the thermosetting composition for an optical semiconductor of the present invention may be inferior in heat resistance and the cured product may become vulnerable to yellowing in a heat environment. A more preferable lower limit is 15 parts by weight and a more preferable upper limit is 100 parts by weight.

The thermosetting composition for an optical semiconductor of the present invention contains a thermosetting agent capable of reacting with the cyclic ether-containing group.
The thermosetting agent is not particularly limited as long as it is an agent capable of reacting with the cyclic ether-containing group of the silicone resin, and examples of the agent include aliphatic amines such as ethylenediamine, triethylenepentamine, hexamethylenediamine, dimer acid modified ethylenediamine, N-ethylaminopiperazine and isophorone diamine; aomatic amines such as m-phenylenediamine, p-phenylenediamine, 3,3'-diaminodiphenyl sulfone, 4,4'-diaminodiphenyl sulfone, 4,4'-diaminodiphenyl methane and 4,4'-diaminodiphenyl ether; mercaptans such as mercapto-propionic acid ester and end mercapto compounds of an epoxy resin; phenolic resins such as bisphenol A, bisphenol F, bisphenol AD, bisphenol S, tetramethyl bisphenol A, tetramethyl bisphenol F, tetramethyl bisphenol AD, tetramethyl bisphenol S, tetrabromo bisphenol A, tetrachloro bisphenol A, tetrafluoro bisphenol A, biphenol, dihydroxynaphthalene, 1,1,1-tris(4-hydroxyphenyl)methane, 4,4-(1-(4-(1-(4-hydroxyphenyl)-1-methylethyl)phenyl)ethylid ene)bisphenol, phenol novolac, cresol novolac, bisphenol A novolac, brominated phenol novolac and brominated bisphenol A novolac; polyols obtained by hydrogenating an aromatic ring of these phenol resins; alicyclic acid anhydrides such as polyazelaic anhydride, methyltetrahydrophthalic anhydride, tetrahydrophthalic anhydride, methylhexahydrophthalic anhydride, hexahydrophthalic anhydride, 5-norbornene-2,3-dicarboxylic anhydride, norbornane-2,3-dicarboxylic anhydride, methyl-5-norbornene-2,3-dicarboxylic anhydride, methyl-norbornane-2,3-dicarboxylic anhydride, cyclohexane-1,2,3-tricarboxylic acid-1,2-anhydride and cyclohexane-1,2,4-tricarboxylic acid-1,2-anhydride; alkyl substituted glutaric anhydrides such as 3-alkylglutaric anhydride having an alkyl group having 1 to 8 carbon atoms optionally branched like 3-methylglutaric anhydride, 2,3-dialkylglutaric anhydride having an alkyl group having 1 to 8 carbon atoms optionally branched like 2-ethyl-3-propylglutaric anhydride and 2,4-dialkylglutaric anhydride having an alkyl group having 1 to 8 carbon atoms optionally branched like 2,4-diethylglutaric anhydride and 2, 4-dimethylglutaric anhydride; aromatic acid anhydrides such as phthalic anhydride, trimellitic anhydride and pyromelletic anhydride; imidazoles such as 2-methylimidazole, 2-ethyl-4-methylimidazole and 2-phenylimidazole,and salts thereof; amine adducts obtained by the reaction of the aliphatic amines, the aromatic amines and/or the imidazoles with an epoxy resin; hydrazines such as adipic dihydrazide; tertiary amines such as dimethylbenzylamine and 1, 8-diazabicyclo (5, 4, 0) undecene-7; organic phosphines such as triphenylphosphine; dicyandiamide and the like. Among them, acid anhydrides such as alicyclic acid anhydrides, alkyl substituted glutaric anhydrides and aromatic acid anhydrides are preferable, and alicyclic acid anhydrides and alkyl substituted glutaric anhydrides are more preferable, and methylhexahydrophthalic anhydride, hexahydrophthalic anhydride, norbornane-2,3-dicarboxylic anhydride, methyl-norbornane-2,3-dicarboxylic anhydride, cyclohexane-1,2,3-tricarboxylic acid-1,2-anhydride, cyclohexane-1,2,4-tricarboxylic acid-1,2-anhydride, and 2,4-diethylglutaric anhydride are particularly preferable. These thermosetting agents may be used alone or in combination of two or more kinds. Here, when the silicone resin contains the bifunctional silicone resin described above, these thermosetting agents can also react with the glycidyl-containing group of the bifunctional silicone resin.

An amount of the thermosetting agent to be blended is not particularly limited, but the amount preferably has a lower limit of 1 part by weight and an upper limit of 200 parts by weight with respect to 100 parts by weight of the silicone resin (when the bifunctional silicone resin is contained, it refers to a total of the silicone resin and the bifunctional silicone resin). When the amount falls within this range, a crosslinking reaction of the thermosetting composition for an optical semiconductor of the present invention adequately proceeds, and the thermosetting composition has excellent heat resistance and lightfastness and has adequately low moisture permeability. A more preferable lower limit is 5 parts by weight and a more preferable upper limit is 120 parts by weight.

The thermosetting composition for an optical semiconductor of the present invention preferably further contains a curing accelerator.
The curing accelerator is not particularly limited, and examples of the curing accelerator include imidazoles such as 2-methylimidazole and 2-ethyl-4-methylimidazole; tertiary amines such as 1,8-diazabicyclo(5,4,0)undecene-7 and salts thereof; phosphines such as triphenylphosphine; phosphonium salts such as triphenylphosphonium bromide; aminotriazoles; metal catalysts such as tin type catalysts, for example, tin octylate and dibutyl tin dilaurate, zinc type catalysts, for example, zinc octylate, and acetylacetonates of, for example, aluminum, chromium, cobalt or zirconium, and the like. These curing accelerators may be used alone or in combination of two or more kinds.

An amount of the curing accelerator to be blended is not particularly limited, but the amount preferably has a lower limit of 0.01 parts by weight and an upper limit of 5 parts by weight with respect to 100 parts by weight of the silicone resin (when the bifunctional silicone resin is contained, it refers to a total of the silicone resin and the bifunctional silicone resin). When the amount is less than 0.01 parts by weight, it may not be preferable since an effect of adding the curing accelerator is not achieved, and when the amount is more than 5 parts by weight, it may not be preferable since the cured product is colored or the heat resistance and the lightfastness thereof are deteriorated significantly. A more preferable lower limit is 0.05 parts by weight and a more preferable upper limit is 1.5 parts by weight.

The thermosetting composition for an optical semiconductor of the present invention preferably further contains a silicon oxide fine particle (hereinafter, also referred to as fine powder silica) surface-treated with an organic silicon type compound. The thermosetting composition for an optical semiconductor of the present invention containing such fine powder silica becomes excellent in mechanical strength and transparency of its cured product.
That is, the fine powder silica has a highly lipophilic surface since the organic silicon type compound exists at the surface of the silicon oxide fine particle and has excellent dispersibility in the highly lipophilic silicone resin described above. It is considered that this excellent dispersibility of the fine powder silica contributes to the improvement of mechanical strength of the cured product of the thermosetting composition for an optical semiconductor of the present invention, and can prevent the occurrence of the voids and the like to retain high transparency of the cured product. Here, on the other hand, in untreated silicon oxide fine particles which are not subjected to surface treatment with the organic silicon type compound, since a silanol group exists at the surface of the silicon oxide fine particle, the fine particle has a highly hydrophilic surface and has low dispersibility in the highly lipophilic silicone resin described above, and it is considered that in the resin composition containing such an untreated silicon oxide type fine particles, the mechanical strength of the cured product of the resin composition is low and voids and the like are produced on the interface between the silicon oxide fine particle and the resin, and light scattering due to the silicon oxide fine particles being not dispersed occurs and the transparency of the cured product is deteriorated.

The form of the silicon oxide fine particle is not particularly limited, and examples of the silicon oxide fine particle include silicas produced by a dry method such as fumed silica and melted silica, silicas produced by a wet method such as colloidal silica, sol gel silica and precipitated silica, and the like. Among them, fumed silica, having less volatile content and enabling to attain high transparency, is suitably used.

The size of the silicon oxide fine particle is not particularly limited, but a primary particle diameter of the silicon oxide fine particle preferably has a lower limit of 5 nm and an upper limit of 200 nm. When the primary particle diameter is less than 5 nm, the dispersibility of the fine powder silica obtained by surface treating the silicon oxide fine particle with the organic silicon type compound may be deteriorated, and the transparency of the cured product of the thermosetting composition for an optical semiconductor of the present invention may be poor. When the primary particle diameter is more than 200 nm, light scattering resulting from the fine powder silica obtained by surface treating the silicon oxide fine particle with the organic silicon type compound may tend to occur and the transparency of the cured product of the thermosetting composition for an optical semiconductor of the present invention may be deteriorated. Amore preferable lower limit is 8 nm and a more preferable upper limit is 150 nm. Here, the primary particle diameter of the silicon oxide fine particle refers to an average value of diameters of spheres when the silicon oxide fine particle is spherical, and refers to an average value of major axes when the silicon oxide fine particle is non spherical.

The silicon oxide fine particle is surface-treated with the organic silicon type compound.
The organic silicon type compound is not particularly limited, and examples of the organic silicon type compound include silane type compounds having an alkyl group, silicon type compounds having a siloxane skeleton such as dimethylsiloxane, silicon type compounds having an amino group, silicon type compounds having a (meth)acrylic group, silicon type compounds having an epoxy group, and the like. Here, the (meth)acryl means acryl or methacryl.

The organic silicon type compound is preferably a compound which is chemically coupled with the surface of the silicon oxide fine particle, and among them, it is preferably an alkyl group-containing silane type compound having a structure expressed by the following formula (17), (18) or (19):

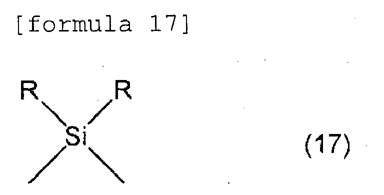

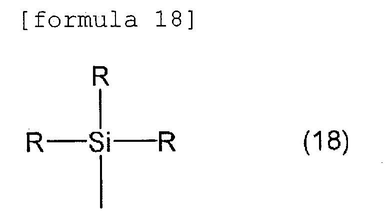

and

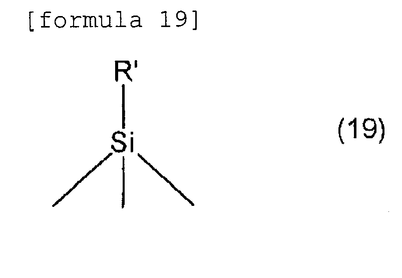

In the formulas (17) and (18), R represents an alkyl group having 1 to 3 carbon atoms, and in the formula (19), R' represents an alkyl group having 4 to 8 carbon atoms.

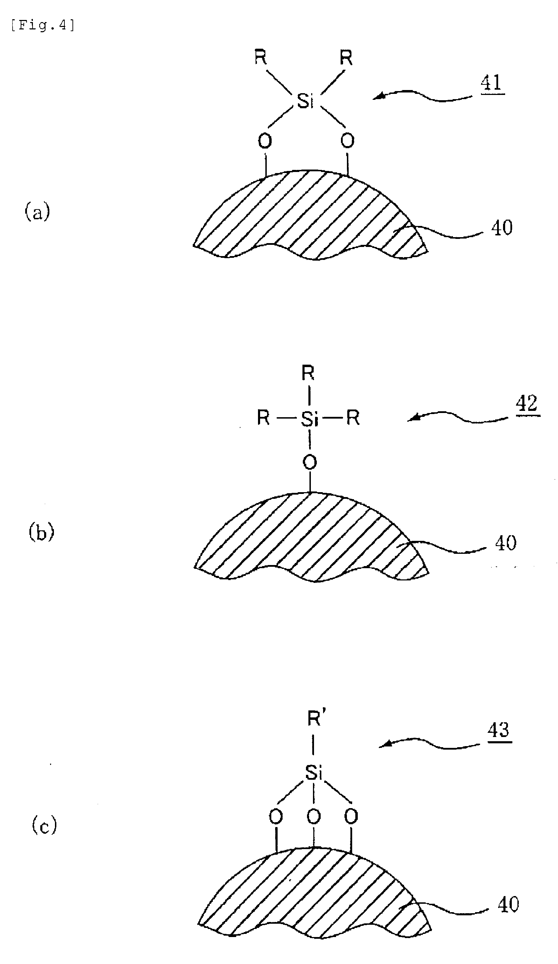

The alkyl group-containing silane type compounds having structures expressed by the formulas (17), (18) and (19) are those in which as shown in Figs. 4(a), 4(b) and 4(c), bonds of a silicon atom in the alkyl group-containing silane type compound 41, 42 or 43 other than the bonds coupled with an alkyl group expressed by R or R' are reacted with a silanol group of the surface of the silicon oxide fine particle 40 to form a chemical bond. Figs. 4(a), 4(b) and 4(c) are sectional views schematically showing a state in which alkyl group-containing silane type compounds having structures expressed by the formulas (17), (18) and (19) are coupled with the surface of the silicon oxide fine particle.

In the thermosetting composition for an optical semiconductor of the present invention, when the organic silicon type compound, with which the silicon oxide fine particle is surface-treated, is an alkyl group-containing silane type compound having a structure expressed by the formula (17) or (18), the fine powder silica becomes excellent in dispersibility in the silicone resin described above, and the thermosetting composition for an optical semiconductor of the present invention becomes excellent in the mechanical strength, the transparency, the heat resistance and the adhesion to the housing materials and the like of its cured product. Also, it is preferable since it becomes possible to pack the fine powder silica in high density while maintaining the viscosity of the thermosetting composition for an optical semiconductor of the present invention at a desired level. In the formula (17) or (18), R has a lower limit of 1 carbon atom and an upper limit of 3 carbon atoms. When the R has more than 3 carbon atoms, the heat resistance of the organic silicon type compound may be deteriorated and the heat resistance of the thermosetting composition for an optical semiconductor of the present invention may be deteriorated.

Further, when the organic silicon type compound, with which the silicon oxide fine particle is surface-treated, is an alkyl group-containing silane type compound having a structure expressed by the formula (19), the fine powder silica becomes excellent in dispersibility in the silicone resin described above, and the thermosetting composition for an optical semiconductor of the present invention becomes excellent in the mechanical strength, the transparency, the heat resistance and the adhesion to the housing materials or the like of its cured product. In the formula (19), R' has a lower limit of 4 and an upper limit of 8 carbon atoms. When the R' has less than 4 carbon atoms, the fine powder silica may become inadequate in dispersibility in the thermosetting composition for an optical semiconductor of the present invention containing the silicone resin described above and therefore this may causes a problem that the transparency of the cured product of the thermosetting composition for an optical semiconductor of the present invention cannot be secured. When the R' has more than 8 carbon atoms, the heat resistance of the organic silicon type compound may be deteriorated and the heat resistance of the thermosetting composition for an optical semiconductor of the present invention may be deteriorated.

The alkyl group-containing silane type compound having a structure expressed by the formula (17), namely, a compound, which is coupled with the surface of the silicon oxide fine particle in a state shown in Fig. 4(a), is not particularly limited, but this compound is preferably a compound having a dimethylsilyl group, and specific examples of the compound include dimethylsilyl dichloride, dimethyldimethoxysilane and the like.

Further, the alkyl group-containing silane type compound having a structure expressed by the formula (18), namely, a compound, which is coupled with the surface of the silicon oxide fine particle in a state shown in Fig. 4(b), is not particularly limited, but this compound is preferably a compound having a trimethylsilyl group, and specific examples of the compound include hexamethyldisilazane, trimethylsilyl chloride, trimethylmethoxysilane and the like.

Further, the alkyl group-containing silane type compound having a structure expressed by the formula (19), namely, a compound, which is coupled with the surface of the silicon oxide fine particle in a state shown in Fig. 4(c), is not particularly limited, and examples of the compound include octylsilane trichloride, octyltrimethoxysilane and the like.

A BET specific surface area of the silicon oxide fine particle (fine powder silica) surface-treated with the organic silicon type compound preferably has a lower limit of 30 m²/g and an upper limit of 400 m²/g. When the BET specific surface area is less than 30 m²/g, light scattering resulting from the fine powder silica occurs in the cured product of the thermosetting composition for an optical semiconductor of the present invention and therefore it becomes difficult to secure the transparency of the cured product. When the BET specific surface area is more than 400 m²/g, the silicon oxide fine particle may become low in dispersibility in the thermosetting composition for an optical semiconductor of the present invention and therefore the mechanical strength and the transparency of the cured product of the thermosetting composition for an optical semiconductor of the present invention may become inadequate. More preferable lower limit is 50 m²/g and more preferable upper limit is 350 m²/g.

In the fine powder silica, a ratio of the organic silicon type compound with respect to the silicon oxide fine particle is not particularly limited, but the ratio preferably has a lower limit of 0.1 parts by weight and an upper limit of 15 parts by weight with respect to 100 parts by weight of the silicon oxide fine particle. When the ratio is less than 0.1 parts by weight, the surface treatment of the silicon oxide fine particle with the organic silicon type compound may become inadequate and the dispersibility of the fine powder silica in the thermosetting composition for an optical semiconductor of the present invention may be deteriorated and therefore the mechanical strength and the transparency of the cured product may become inadequate. When the ratio is more than 15 parts by weight, the organic silicon compound not reacting with the surface of the fine powder silica may remain in large quantity and this may cause the deterioration of heat resistance or the decrease in thickness of the cured product.

A method of surface treating the silicon oxide fine particle with the organic silicon type compound is not particularly limited, and examples of the method include direct treatment methods such as a dry method in which the silicon oxide fine particles are added to a mixer which can stir the content at a high speed such as Henschel mixer, V-type mixer or the like, and then the organic silicon type compound is added directly or in the form of an aqueous alcohol solution, a solution of organic solvent or an aqueous solution while stirring the silicon oxide fine particles, a slurry method in which the organic silicon type compound is added to the slurry of the silicon oxide fine particles and a spraying method in which the organic silicon type compound is added by spraying after the step of drying the silicon oxide fine particles; and an integral blending method in which the organic silicon type compound is directly added in mixing the silicon oxide fine particles and a matrix resin such as a silicone resin described later when preparing the thermosetting composition for an optical semiconductor of the present invention.

In the thermosetting composition for an optical semiconductor of the present invention, the content of the fine powder silica is not particularly limited, but the content preferably has a lower limit of 1 part by weight and an upper limit of 50 parts by weight with respect to 100 parts by weight of the silicone resin described above. When the content is less than 1 part by weight, the mechanical strength of the cured product of the thermosetting composition for an optical semiconductor of the present invention may become inadequate and therefore the occurrence of cracks may not be adequately prevented, and when the content is more than 50 parts by weight, the viscosity of the thermosetting composition for an optical semiconductor of the present invention may increase, and therefore, for example, when the thermosetting composition is used as a sealing agent of an optical semiconductor device such as an LED, bubbles may be incorporated in the filling process, and thereby voids may be produced, which make the transparency of the cured product deteriorated. A more preferable lower limit is 5 parts by weight and a more preferable upper limit is 40 parts by weight.

Further, it is preferable that the fine powder silica does not aggregate in the thermosetting composition for an optical semiconductor of the present invention and is dispersed in a state of a nearly primary particle. Here, the state of a nearly primary particle means that the fine powder silica does not need to be dispersed as an absolute primary particle in the thermosetting composition for an optical semiconductor of the present invention and it may be agglomerated or aggregated to some extent to exist as an agglomerated particle.
When the fine powder silica exists as the agglomerated particle, a preferable upper limit of the average diameter of the agglomerated particles is 200 nm. When the average diameter is more than 200 nm, light scattering resulting from the fine powder silica may occur, and the transparency of the cured product may become inadequate. A more preferable upper limit is 150 nm. Here, an average diameter of the agglomerated particles refers to an average value of the major axes of the group (agglomerated particle) of the fine powder silica formed by aggregation or the like.

The thermosetting composition for an optical semiconductor of the present invention preferably further contains a fine particle having a metal element. By containing the fine particles, a refractive index of the thermosetting composition for an optical semiconductor of the present invention is increased and the ability of the optical semiconductor device, such as an LED, obtained by using the thermosetting composition for an optical semiconductor of the present invention to take out light becomes excellent.

An average primary particle diameter of the fine particles preferably has an upper limit of 20 nm. When the average primary particle diameter is more than 20 nm, light scattering resulting from the fine particle may occur in the thermosetting composition for an optical semiconductor of the present invention, and the thermosetting composition for an optical semiconductor of the present invention may become clouded. A more preferable lower limit is 3 nm and a more preferable upper limit is 15 nm.

The fine particle has a metal element.
In the fine particles, 80% or more of metal elements existing in the fine particles are preferably at least one kind of metal element selected from the group consisting of Al, In, Ge, Sn, Ti, Zr and Hf. When this percentage is less than 80%, a refractive index of the thermosetting composition for an optical semiconductor of the present invention may not be increased much and the ability of the optical semiconductor device obtained by using the thermosetting composition for an optical semiconductor of the present invention to take out light may be inferior.

The fine particle is not particularly limited as long as it has the metal element, but among them, the fine particle having zirconium is preferable due to improved refractive index and high transparency of light from the viewpoint that the ability to improve the refractive index of the thermosetting composition for an optical semiconductor of the present invention is excellent.

An amount of the fine particle to be blended is not particularly limited, but the amount preferably has a lower limit of 1 part by weight and an upper limit of 100 parts by weight with respect to 100 parts by weight of the silicone resin. When the amount is less than 1 part by weight, the refractive index of the thermosetting composition for an optical semiconductor of the present invention may be hardly improved, and when the amount is more than 100 parts by weight, the control of viscosity becomes difficult. A more preferable lower limit is 5 parts by weight and a more preferable upper limit is 80 parts by weight.

A preferable lower limit of the refractive index of such fine particles is 1.50. When the refractive index is less than 1.50, the refractive index of the thermosetting composition for an optical semiconductor of the present invention may not be increased and the ability of the optical semiconductor device obtained by using the thermosetting composition for an optical semiconductor of the present invention to take out light may become inadequate.
Here, in the present description, the refractive index is a value determined by measuring a refractive index for a sodium D-line (589. 3 nm) at a measuring temperature of 20°C with a refractometer (Abbe refractometer)

The thermosetting composition for an optical semiconductor of the present invention may contain a coupling agent in order to impart an adhesive property.
The coupling agent is not particularly limited, and examples of the coupling agent include silane coupling agents such as vinyl triethoxysilane, vinyl trimethoxysilane, 3-glycidoxypropyl trimethoxysilane, 2-(3,4-epoxycyclohexyl)ethyl trimethoxysilane, γ-methacryloxypropyl trimethoxysilane, γ-aminopropyl trimethoxysilan, and N-phenyl-3-aminopropyl trimethoxysilane. These coupling agents may be used alone or in combination of two or more kinds.

A ratio of the coupling agent to be blended preferably has a lower limit of 0.1 parts by weight and an upper limit of 5 parts by weight with respect to 100 parts by weight of the silicone resin. When the ratio is less than 0.1 parts by weight, an effect of blending the coupling agent may not be adequately exhibited, and when the ratio is more than 5 parts by weight, an excessive coupling agent may be volatilized and this may cause a decrease in thickness or the like of the cured product when the thermosetting composition for an optical semiconductor of the present invention is cured.

The thermosetting composition for an optical semiconductor of the present invention may contain an antioxidant in order to improve heat resistance.
The antioxidant is not particularly limited, and examples of the antioxidant include phenolic type antioxidants such as 2,6-di-t-butyl-4-methyl phenol, 2,5-di-t-amylhydroquinon, 2,5-di-t-butylhydroquinon, 4,4'-butylidenebis(3-methyl-6-t-butylphenol), 2,2'-methylenebis(4-methyl-6-t-butylphenol) and 2,2'-methylenebis(4-ethyl-6-t-butylphenol); phosphorus type antioxidants such as triphenyl phosphite, tridecyl phosphite, (nonyldiphenyl) phosphite, 9,10-dihydro-9-oxa-10-phospha-phenanthrene and 9,10-dihydro-9-oxa-10-phospha-phenanthrene-10-oxide; sulfur type antioxidants such as dilauryl 3,3'-thiodipropionate, ditridecyl-3,3'-thiodipropionate and [4,4'-thiobis(3-methyl-6-tert-butylphenyl)]-bis(alkylthiopr opionate) ; and metal type antioxidants such as fullerene, iron, zinc, and nickel as other antioxidants. These antioxidants may be used alone or in combination of two or more kinds.

A ratio of the antioxidant to be blended preferably has a lower limit of 0.001 parts by weight and an upper limit of 2 parts by weight with respect to 100 parts by weight of the silicone resin. When the ratio is less than 0.001 parts by weight, an effect of blending the antioxidant may not be adequately exhibited, and when the ratio is more than 2 parts by weight, the antioxidant may be volatilized and this may cause a decrease in thickness or the like of the cured product, or the cured product may become brittle when the thermosetting composition for an optical semiconductor of the present invention is cured.

The thermosetting composition for an optical semiconductor of the present invention may include an additive such as an antifoaming agent, a coloring agent, a phosphor, a modifier, a leveling agent, a light diffusing agent, a thermally-conductive filler or a flame retarder as required.

The viscosity of the thermosetting composition for an optical semiconductor of the present invention is not particularly limited, but a preferable lower limit of the viscosity is 500 mPa·s and a preferable upper limit is 50000 mPa·s. When the viscosity is less than 500 mPa·s, the thermosetting composition for an optical semiconductor causes sagging in using as a sealing agent of the optical semiconductor device and the optical semiconductor device may not be sealed, and when the viscosity is more than 50000 mPa·s, the optical semiconductor device may not be sealed uniformly and precisely. Amore preferable lower limit is 1000 mPa·s and a more preferable upper limit is 10000 mPa·s. Here, in the present description, the viscosity is a value measured at 25°C and at a rotational speed of 5 rpm using an E type viscometer (manufactured by Toki Sangyo Co., Ltd., TV-22).

The thermosetting composition for an optical semiconductor of the present invention preferably has an initial light transmittance of 90% or more. When the initial light transmittance is less than 90%, optical properties of the optical semiconductor device obtained by using the thermosetting composition for an optical semiconductor of the present invention become inadequate. Here, the initial light transmittance is a value determined by measuring light transmittance at a wavelength of 400 nm on the cured product with a thickness of 1 mm obtained by curing the thermosetting composition for an optical semiconductor of the present invention using "U-4000" manufactured by Hitachi, Ltd.

Further, in the thermosetting composition for an optical semiconductor of the present invention, it is preferable that a rate of decrease of the light transmittance after a lightfastness test is less than 10%. When the rate of decrease of the light transmittance is 10% or more, optical properties of the optical semiconductor device obtained by using the thermosetting composition for an optical semiconductor of the present invention become inadequate. Here, the lightfastness test is a test of irradiating light from a high-pressure mercury lamp equipped with a filter to cut off light with a wavelength of 340 nm or less at 100 mW/cm² for 24 hours to the cured product with a thickness of 1 mm obtained by curing the thermosetting composition for an optical semiconductor of the present invention, and the light transmittance after a lightfastness test is a value determined by measuring the light transmittance at a wavelength of 400 nm on the cured product after the lightfastness test using "U-4000" manufactured by Hitachi, Ltd.

Further, in the thermosetting composition for an optical semiconductor of the present invention, it is preferable that a rate of decrease of the light transmittance after a heat resistance test is less than 10%. When the rate of decrease of the light transmittance is 10% or more, optical properties of the optical semiconductor device obtained by using the thermosetting composition for an optical semiconductor of the present invention become inadequate. Here, the heat resistance test is a test of leaving standing the cured product with a thickness of 1 mm obtained by curing the thermosetting composition for an optical semiconductor of the present invention in an oven of 150°C for 1000 hours, and the light transmittance after a heat resistance test is a value determined by measuring the light transmittance at a wavelength of 400 nm on the cured product after the heat resistance test using "U-4000" manufactured by Hitachi, Ltd.

Further, the thermosetting composition for an optical semiconductor of the present invention preferably has a decrease in thickness of the cured product less than 3%. When the decrease in thickness of the cured product is 3% or more, optical properties of the optical semiconductor device obtained by using the thermosetting composition for an optical semiconductor of the present invention become inadequate. Here, the decrease in thickness is determined by leaving standing the cured product with a thickness of 1 mm obtained by curing the thermosetting composition for an optical semiconductor of the present invention in an oven of 150°C for 1000 hours and calculating a change in thickness before and after the test.

The thermosetting composition for an optical semiconductor of the present invention is highly transparent, is free-from decrease in thickness or discoloration of the cured product due to heat generation or light emitting of a light emitting device, and is superior in heat resistance and lightfastness and has excellent adhesion to a housing material since the thermosetting composition contains the silicone resin having the cyclic ether-containing group and having the structural unit expressed by the formula (1) and the structural unit expressed by the formula (2) described above as the principal components, wherein the content of the structural unit expressed by the formula (1) is 0.6 to 0.95 (on a molar basis) and the content of the structural unit expressed by the formula (2) is 0.05 to 0.4 (on a molar basis) when total number of the structural units contained is taken as 1, and the content of the cyclic ether-containing group is 5 to 40 mol%.

A method of producing the thermosetting composition for an optical semiconductor of the present invention is not particularly limited, and examples of the method include such as a method in which predetermined amounts of the silicone resin described above, the thermosetting agent, the fine particles and the curing accelerator, and the additives are mixed at normal temperature or under heating using a mixer such as a homodisper, a homomixer, a universal mixer, a planetary mixer, a kneader, a three roll, or a bead mill.

Applications of the thermosetting composition for an optical semiconductor of the present invention is not particularly limited, and the thermosetting composition can be applied to, for example, a sealing agent, a housing material, a die bond material for connecting to such as a lead electrode or a heat sink, an underfill material for mounting the light emitting device of the optical semiconductor device such as a light emitting diode by a flip-chip, and a passivation film on the light emitting device. Among them, the thermosetting composition can be suitably used as the sealing agent, the underfill material and the die bond material.
A sealing agent for an optical semiconductor device obtained by using the thermosetting composition for an optical semiconductor of the present invention also constitutes the present invention.
A die bond material for an optical semiconductor device obtained by using the thermosetting composition for an optical semiconductor of the present invention also constitutes the present invention.
An underfill material for an optical semiconductor device obtained by using the thermosetting composition for an optical semiconductor of the present invention also constitutes the present invention.

### (Die bond material for optical semiconductor device)

The die bond material for an optical semiconductor device of the present invention is superior in heat resistance, lightfastness and an adhesive property since the die bond material is made of the thermosetting composition for an optical semiconductor of the present invention. Also, since the die bond material for an optical semiconductor device of the present invention can retain high transparency under the conditions of use, it absorbs light in the housing material direction of the optical semiconductor device without loss of the light, and therefore it can contribute to provide an optical semiconductor device with high luminous efficiency.

The die bond material for an optical semiconductor device of the present invention preferably further contains highly thermally-conductive fine particles. In the present description, the highly thermally-conductive fine particle refers to a fine particle having high thermal conductivity.
By blending the fine particles having high thermal conductivity, the die bond material for an optical semiconductor device of the present invention becomes superior in a heat releasing property, and if a heat sink is provided in a package of an optical semiconductor apparatus and an optical semiconductor is secured on the heat sink using the die bond material for an optical semiconductor, it is preferable since it becomes possible to mitigate thermal damage to the optical semiconductor significantly.

Thermal conductivity of a highly thermally-conductive fine particle, which is blended in the die bond material for an optical semiconductor device of the present invention, preferably has a lower limit of 60 kcal/m·hr·°C. When the thermal conductivity is less than 60 kcal/m·hr·°C, an adequate heat releasing property can be achieved only if the increased amount of the thermally-conductive fine particle is added, and therefore the control of viscosity may become difficult.

The highly thermally-conductive fine particle is not particularly limited, and examples of the fine particle include metal particles such as nickel, tin, aluminum, gold, silver, copper, iron, cobalt, indium and alloys thereof; metal nitrides such as boron nitride and aluminum nitride; metal oxide such as aluminum oxide, magnesium oxide and titanium oxide; carbon compound particles such as silicon carbide, graphite, diamond, amorphous carbon, carbon black and carbon fiber; particles coated with metal prepared by forming a layer of another metal on a resin particle or a metal particle, and the like.
As the particle coated with metal, for example, particles obtained by plating the resin particle with gold or silver are preferable.

Further, if the particle including at least one selected from the group consisting of gold, silver and copper is contained, it is preferable since the die bond material becomes a material having thermal conductivity as well as high electric conductivity. If the die bond material having electric conductivity is used, it is preferable since an electrode pad can be electrically connected to the lead electrode by the die bond material in the case where an optical semiconductor device of a structure in which the electrode pads are provided on both surfaces of the light emitting device is prepared.

Further, these fine particles having high thermal conductivity are preferably subjected to surface treatment so that the fine particles can be uniformly mixed at high blend ratio.

An amount of the highly thermally-conductive fine particles to be blended preferably has a lower limit of 10% by weight and an upper limit of 95% by weight. When the amount is less than 10% by weight, adequate thermal conductivity may not be attained, and when the amount is more than 95% by weight, the control of viscosity may become difficult.

### (Underfill material for optical semiconductor device)

Since the underfill material for an optical semiconductor device of the present invention is obtained by using the thermosetting composition for an optical semiconductor of the present invention, it is suitable for the purpose of mitigating stress on an electrode bump for connection in mounting a flip-chip, which is an intended purpose of the underfill material, and at the same time it is superior in lightfastness, heat resistance and an adhesive property and can be suitably used. Thus, the underfill material for an optical semiconductor device of the present invention may be cured as an underfill material at the time of mounting of the flip-chip, and then a sealing agent may be cured, or when the same material as the underfill material is used for a sealing agent, the underfill material may be dual as a sealing agent. The latter method is a more preferable production method because a tact time is shortened.

An optical semiconductor device can be produced using at least one of the sealing agent for an optical semiconductor device, the die bond material for an optical semiconductor device and the underfill material for an optical semiconductor device, which are obtained by using the thermosetting composition for an optical semiconductor of the present invention.

The light emitting device is not particularly limited, and examples of the light emitting device include a multilayer formed by laminating semiconductor materials on a substrate in the case where the optical semiconductor device is a light emitting diode. In this case, examples of the semiconductor materials include such as GaAs, GaP, GaAlAs, GaAsP, AlGaInP, GaN, InN, AlN, InGaAlN, and SiC.
Examples of the substrate include such as sapphire, spinel, SiC, Si, ZnO, and GaN single crystal. Further, a buffer layer may be formed between the substrate and the semiconductor material as required. Examples of the buffer layer include such as a GaN buffer layer and an AlN buffer layer.

A method of laminating semiconductor materials on a substrate is not particularly limited, and examples of the method include such as a MOCVD method, a HDVPE method, and a liquid phase growth method.
Examples of the structure of the light emitting device include such as a homojunction having a MIS junction, a PN junction, or a PIN junction, a heterojunction, and a double heterostructure. Further, a single quantum well structure or a multiple quantum well structure may be employed.

When the light emitting device is sealed with the sealing agent for an optical semiconductor device of the present invention, another sealing agent may be used in conjunction with the sealing agent of the present invention. In this case, after the light emitting device is sealed with the sealing agent for an optical semiconductor device of the present invention, the periphery of the sealed portion may be sealed with the another sealing agent, or after the light emitting device is sealed with the another sealing agent, the periphery of the sealed portion may be sealed with the sealing agent for an optical semiconductor device of the present invention.
The another sealing agent is not particularly limited, and examples of the sealing agent include such as an epoxy resin, a silicone resin, an acrylic resin, a urea resin, an imide resin, and glass. Further, a solution containing a surface modifier may be applied to the surface to provide a protective layer.

A method of sealing the light emitting device with the sealing agent for an optical semiconductor device of the present invention is not particularly limited, and example of the method include a method in which the sealing agent for an optical semiconductor device of the present invention is filled into a mold in advance, and into this, a lead frame and the like to which the light emitting device is secured is immersed, and then the sealing agent is cured, a method in which the sealing agent for an optical semiconductor device of the present invention is filled into a mold in which the light emitting device is previously inserted, and then the sealing agent is cured, and the like.
Examples of the method of filling the sealing agent for an optical semiconductor device of the present invention include such as filling by a dispenser, transfer molding, and injection molding. Furthermore, examples of other sealing methods include such as a method in which the sealing agent for an optical semiconductor device of the present invention is applied onto the light emitting device through dropwise addition, mimeographic printing, screen printing or a mask and then cured, and a method in which the sealing agent for an optical semiconductor device of the present invention is filled with a dispenser and the like into a cup and the like in which the light emitting device is arranged on the bottom and then cured.
Furthermore, the sealing agent for an optical semiconductor device of the present invention can also be employed as a die bond material to secure the light emitting device to a lead terminal or a package, a passivation film on the light emitting device and a package substrate.

The thermosetting composition for an optical semiconductor of the present invention has high transparency for light of a short wavelength of from blue region to ultraviolet region, is free-from decrease in thickness or discoloration of the cured product due to heat generation or light emitting of a light emitting device to be sealed and is superior in heat resistance and lightfastness when being used as a sealing agent of an optical semiconductor device, and has excellent adhesion to a housing material or the like of the optical semiconductor device when a light emitting device of the optical semiconductor device such as a light emitting diode is sealed with this thermosetting composition, since the silicone resin in the thermosetting composition for an optical semiconductor of the present invention has the cyclic ether-containing group and has the structural unit expressed by the formula (1) and the structural unit expressed by the formula (2), as the principal components, and the content of the structural unit expressed by the formula (1) is 0.6 to 0.95 (on a molar basis) and the content of the structural unit expressed by the formula (2) is 0.05 to 0.4 (on a molar basis) when total number of the structural units contained is taken as 1, and the content of the cyclic ether-containing group is 5 to 40 mol%.
Here, the housing material is not particularly limited, and examples of the housing material include publicly known materials including aluminum, polyphthalamide resin (PPA), polybutylene terephthalate resin (PBT) and the like.

An optical semiconductor device obtained by using the thermosetting composition for an optical semiconductor of the present invention, the sealing agent for an optical semiconductor device of the present invention, the die bond material for an optical semiconductor device of the present invention and/or the underfill material for an optical semiconductor device of the present invention also constitutes the present invention.

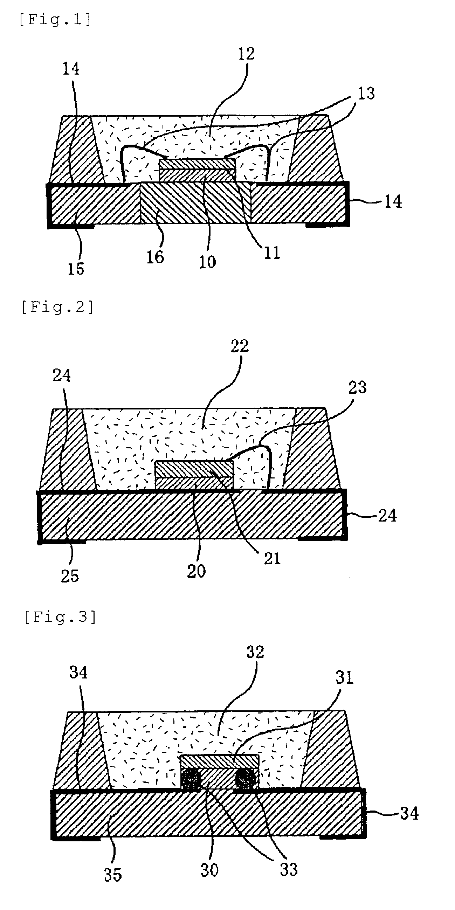

Fig. 1 and Fig. 2 are sectional views schematically showing an example of an optical semiconductor device obtained by using the sealing agent for an optical semiconductor device and the die bond material for an optical semiconductor device of the present invention, and Fig. 3 is a sectional views schematically showing an example of an optical semiconductor device obtained by using the sealing agent for an optical semiconductor device and the underfill material for an optical semiconductor device of the present invention.

In the optical semiconductor device shown in Fig. 1, a light emitting device 11 is provided on a heat sink 16 thorough the die bond material 10 for an optical semiconductor device of the present invention, and the light emitting device 11 is electrically connected to two lead electrodes 14 extending from a top side and along a side and to a bottom of a housing material through a gold wire 13. The light emitting device 11, the die bond material 10 for an optical semiconductor device of the present invention and the gold wire 13 are sealed with the sealing agent 12 for an optical semiconductor device of the present invention.

Fig. 2 shows an optical semiconductor device in the case where the die bond material for an optical semiconductor device of the present invention has high electric conductivity by containing the particle including at least one selected from the group consisting of gold, silver and copper.
In the optical semiconductor device shown in Fig. 2, a light emitting device 21 is provided thorough the die bond material 20 for an optical semiconductor device of the present invention, and an end of one lead electrode 24 of two lead electrodes 24 extending from a top side and along a side and to a bottom of a housing material 25 is arranged between the die bond material 20 for an optical semiconductor device of the present invention and the housing material 25 and is electrically connected to the light emitting device 21 through the die bond material 20 for an optical semiconductor device of the present invention, and the other lead electrode 24 is electrically connected to the light emitting device 21 through a gold wire 23. The light emitting device 21, the die bond material 20 for an optical semiconductor device of the present invention and the gold wire 23 are sealed with the sealing agent 22 for an optical semiconductor device of the present invention.

In the optical semiconductor device of the present invention shown in Fig. 3, a light emitting device 31 is provided through a bump 33, and the underfill material 30 for an optical semiconductor device of the present invention is formed between the light emitting device 31 and a housing material 35. Each end of two lead electrodes 34 extending from a top side and along a side and to a bottom of a housing material 35 is arranged between the bump 33 and the housing material 35 and is electrically connected to the light emitting device 31. The light emitting device 31 and the underfill material 30 for an optical semiconductor device of the present invention are sealed with the sealing agent 32 for an optical semiconductor device of the present invention.
In the optical semiconductor device of the present invention shown in Fig. 3, the underfill material 30 for an optical semiconductor device of the present invention is formed by filling the underfill material 30 into a space formed below the light emitting device 31 from a side gap after connecting the light emitting device 31 to the lead electrodes 34 with bumps 33.

Examples of applications of the optical semiconductor device of the present invention include, specifically, such as a light emitting diode, semiconductor laser, and a photocoupler. Such an optical semiconductor device of the present invention can be suitably used for such as a backlight of liquid crystal display and the like, an illumination lamp, various sensors, a printer, a light source of a copying machine and the like, a light source for automobile instruments, a signal light, an indicating light, a display device, a light source of a planar light-emitting device, a display, an illumination, various lights, and a switching device.

### EFFECTS OF THE INVENTION

In accordance with the present invention, it is possible to provide a thermosetting composition for an optical semiconductor which is highly transparent, is free-from decrease in thickness or discoloration of a cured product due to heat generation or light emitting of a light emitting device, is superior in heat resistance and lightfastness, and has excellent adhesion to a housing material or the like, a sealing agent for an optical semiconductor device, a die bond material for an optical semiconductor device, an underfill material for an optical semiconductor device, and an optical semiconductor device obtained by using the thermosetting composition for an optical semiconductor, the sealing agent for an optical semiconductor device, the die bond material for an optical semiconductor device and/or the underfill material for an optical semiconductor device.

### BEST MODE FOR CARRYING OUT THE INVENTION

Hereinafter, the present invention will be described in more detail by way of Examples, but the present invention is not limited to these Examples.

### (Synthetic Example 1)

To a 2000 milliliter separable flask equipped with a thermometer and a dropping apparatus, dimethyldimethoxysilane (750 g) and 3-glycidoxypropyl (methyl) dimethoxysilane (150 g) were added, and the resulting mixture was stirred at 50°C. To this, potassium hydroxide (1.9 g)/water (250 g) were added dropwise slowly, and the resulting mixture was stirred at 50°C for 6 hours after the completion of adding dropwise. To this, acetic acid (2.1 g) was added, and volatile components were removed under a reduced pressure and potassium acetate was filtered out to obtain a polymer. The obtained polymer was washed with hexane/water and volatile components were removed under a reduced pressure to obtain a polymer A. The polymer A had a molecular weight Mn of 11000 and a molecular weight Mw of 25000, and the formula of the polymer A was

(Me₂SiO_{2/2})_{0.90}(EpMeSiO_{2/2})_{0.10}

from 29Si NMR analysis, and the content of a 3-glycidoxypropyl group was 14 mol% and epoxy equivalent was 760 g/eq. The content of an alkoxy group was 0.2 mol%.
Here, tetrahydrofuran (1 mL) was added to the polymer A (10 mg), and the resulting mixture was stirred until the polymer was dissolved. The obtained polymer solution was measured by a GPC method using a measuring apparatus (column: Shodex GPC LF-804(length 300 mm × 2) manufactured by Showa Denko K.K, measuring temperature: 40°C, flow rate: 1 mL/min, solvent: tetrahydrofuran, standard sample: polystyrene) manufactured by Waters Corporation to determine a molecular weight. Further, the epoxy equivalent was determined according to JIS K-7236.
The content of an alkoxy group was determined from 1H-NMR.

### (Synthetic Example 2)

To a 2000 milliliter separable flask equipped with a thermometer and a dropping apparatus, dimethyldimethoxysilane (540 g) and 2-(3,4-epoxycyclohexyl)ethyl-trimethoxysilane (60 g) were added, and the resulting mixture was stirred at 50°C. To this, potassium hydroxide (1.3 g)/water (175 g) were added dropwise slowly, and the resulting mixture was stirred at 50°C for 6 hours after the completion of adding dropwise. To this, acetic acid (1.4 g) was added, and volatile components were removed under a reduced pressure and potassium acetate was filtered out to obtain a polymer. The obtained polymer was washed with hexane/water and volatile components were removed under a reduced pressure to obtain a polymer B. The polymer B had a molecular weight Mn of 2100 and a molecular weight Mw of 7300, and the formula of the polymer B was

(Me₂SiO_{2/2})_{0.94}(EpSiO_{3/2})_{0.06}

from 29Si NMR analysis, and the content of a 2-(3,4-epoxycyclohexyl)ethyl group was 9 mol% and epoxy equivalent was 1270 g/eq. The content of an alkoxy group was 1.5 mol%.
Here, the molecular weight and the epoxy equivalent of the polymer B, and the content of an alkoxy group were determined in the same manner as in Synthetic Example 1.

### (Synthetic Example 3)

To a 2000 milliliter separable flask equipped with a thermometer and a dropping apparatus, dimethyldimethoxysilane (440 g) and 3-glycidoxypropyl trimethoxysilane (160 g) were added, and the resulting mixture was stirred at 50°C. To this, potassium hydroxide (1.2 g)/water (170 g) were added dropwise slowly, and the resulting mixture was stirred at 50°C for 6 hours after the completion of adding dropwise. To this, acetic acid (1.3 g) was added, and volatile components were removed under a reduced pressure and potassium acetate was filtered out to obtain a polymer. The obtained polymer was washed with hexane/water and volatile components were removed under a reduced pressure to obtain a polymer C. The polymer C had a molecular weight Mn of 2000 and a molecular weight Mw of 3800, and the formula of the polymer C was

(Me₂SiO_{2/2})_{0.83}(EpSiO_{3/2})_{0.17}

from 29Si NMR analysis, and the content of a 3-glycidoxypropyl group was 22 mol% and epoxy equivalent was 550 g/eq. The content of an alkoxy group was 4 mol%.
Here, the molecular weight and the epoxy equivalent of the polymer C, and the content of an alkoxy group were determined in the same manner as in Synthetic Example 1.

### (Synthetic Example 4)

To a 2000 milliliter separable flask equipped with a thermometer and a dropping apparatus, dimethyldimethoxysilane (440 g) and 2-(3,4-epoxycyclohexyl)ethyl-trimethoxysilane (160 g) were added, and the resulting mixture was stirred at 50°C. To this, potassium hydroxide (1.2 g) /water (170 g) were added dropwise slowly, and the resulting mixture was stirred at 50°C for 6 hours after the completion of adding dropwise. To this, acetic acid (1.3 g) was added, and volatile components were removed under a reduced pressure and potassium acetate was filtered out to obtain a polymer. The obtained polymer was washed with hexane/water and volatile components were removed under a reduced pressure to obtain a polymer D. The polymer D had a molecular weight Mn of 2300 and a molecular weight Mw of 4800, and the formula of the polymer D was

(Me₂SiO_{2/2})_{0.84}(EpSiO_{3/2})_{0.16}

from 29Si NMR analysis, and the content of a 2-(3,4-epoxycyclohexyl)ethyl group was 22 mol% and epoxy equivalent was 550 g/eq. The content of an alkoxy group was 2 mol%.
Here, the molecular weight and the epoxy equivalent of the polymer D, and the content of an alkoxy group were determined in the same manner as in Synthetic Example 1.

### (Synthetic Example 5)

To a 2000 milliliter separable flask equipped with a thermometer and a dropping apparatus, dimethyldimethoxysilane (400 g), methyltrimethoxysilane (100 g) and 3-glycidoxypropyl trimethoxysilane (100 g) were added, and the resulting mixture was stirred at 50°C. To this, potassium hydroxide (1.3 g) /water (180 g) were added dropwise slowly, and the resulting mixture was stirred at 50°C for 6 hours after the completion of adding dropwise. To this, acetic acid (1.4 g) was added, and volatile components were removed under a reduced pressure and potassium acetate was filtered out to obtain a polymer. The obtained polymer was washed with hexane/water and volatile components were removed under a reduced pressure to obtain a polymer E. The polymer E had a molecular weight Mn of 3200 and a molecular weight Mw of 5400, and the formula of the polymer E was

(Me₂SiO_{2/2})_{0.71}(MeSiO_{3/2})_{0.18}(EpSiO_{3/2})_{0.11}

from 29Si NMR analysis, and the content of a 3-glycidoxypropyl group was 15 mol% and epoxy equivalent was 780 g/eq. The content of the alkoxy group was 3 mol%.
Here, the molecular weight and the epoxy equivalent of the polymer E, and the content of an alkoxy group were determined in the same manner as in Synthetic Example 1.

### (Synthetic Example 6)

To a 2000 milliliter separable flask equipped with a thermometer and a dropping apparatus, dimethyldimethoxysilane (350 g), methyltrimethoxysilane (125 g) and 2-(3,4-epoxycyclohexyl)ethyl-trimethoxysilane (125 g) were added, and the resulting mixture was stirred at 50°C. To this, potassium hydroxide (1.2 g) /water (190 g) were added dropwise slowly, and the resulting mixture was stirred at 50°C for 6 hours after the completion of adding dropwise. To this, acetic acid (1.3 g) was added, and volatile components were removed under a reduced pressure and potassium acetate was filtered out to obtain a polymer. The obtained polymer was washed with hexane/water and volatile components were removed under a reduced pressure to obtain a polymer F. The polymer F had a molecular weight Mn of 2900 and a molecular weight Mw of 4600, and the formula of the polymer F was

(Me₂SiO_{2/2})_{0.65}(MeSiO_{3/2})_{0.22}(EpSiO_{3/2})_{0.13}

from 29Si NMR analysis, and the content of a 2-(3,4-epoxycyclohexyl)ethyl group was 19 mol% and epoxy equivalent was 660 g/eq. The content of the alkoxy group was 3.5 mol%.
Here, the molecular weight and the epoxy equivalent of the polymer F, and the content of an alkoxy group were determined in the same manner as in Synthetic Example 1.

### (Synthetic Example 7)

To a 2000 milliliter separable flask equipped with a thermometer and a dropping apparatus, dimethyldimethoxysilane (330 g) and 2-(3,4-epoxycyclohexyl)ethyl-trimethoxysilane (270 g) were added, and the resulting mixture was stirred at 50°C. To this, potassium hydroxide (1.0 g) /water (156 g) were added dropwise slowly, and the resulting mixture was stirred at 50°C for 6 hours after the completion of adding dropwise. To this, acetic acid (1.1 g) was added, and volatile components were removed under a reduced pressure and potassium acetate was filtered out to obtain a polymer. The obtained polymer was washed with hexane/water and volatile components were removed under a reduced pressure to obtain a polymer G. The polymer G had a molecular weight Mn of 1900 and a molecular weight Mw of 4400, and the formula of the polymer G was

(Me₂SiO_{2/2})_{0.70}(EpSiO_{3/2})_{0.30}

from 29Si NMR analysis, and the content of a 2-(3,4-epoxycyclohexyl)ethyl group was 36 mol% and epoxy equivalent was 330 g/eq. The content of the alkoxy group was 4 mol%.
Here, the molecular weight and the epoxy equivalent of the polymer G, and the content of an alkoxy group were determined in the same manner as in Synthetic Example 1.

### (Synthetic Example 8)

To a 2000 milliliter separable flask equipped with a thermometer and a dropping apparatus, dimethyldimethoxysilane (350 g), 3-glycidoxypropyl (methyl) dimethoxysilane (150 g) and methyltrimethoxysilane (100 g) were added, and the resulting mixture was stirred at 50°C. To this, potassium hydroxide (1.2 g) /water (170 g) were added dropwise slowly, and the resulting mixture was stirred at 50°C for 6 hours after the completion of adding dropwise. To this, acetic acid (1.3 g) was added, and volatile components were removed under a reduced pressure and potassium acetate was filtered out to obtain a polymer. The obtained polymer was washed with hexane/water and volatile components were removed under a reduced pressure to obtain a polymer H. The polymer H had a molecular weight Mn of 2200 and a molecular weight Mw of 5200, and the formula of the polymer H was

(Me₂SiO_{2/2})_{0.67}(EpSiO_{2/2})_{0.16}(MeSiO_{3/2})_{0.17}

from 29Si NMR analysis, and the content of a 3-glycidoxypropyl group was 22 mol% and epoxy equivalent was 550 g/eq. The content of the alkoxy group was 2 mol%.
Here, the molecular weight and the epoxy equivalent of the polymer H, and the content of an alkoxy group were determined in the same manner as in Synthetic Example 1.

### (Synthetic Example 9)

To a 2000 milliliter separable flask equipped with a thermometer and a dropping apparatus, dimethyldimethoxysilane (230 g), cyclohexyl(methyl)dimethoxysilane (110 g) and 2-(3,4-epoxycyclohexyl)ethyl-trimethoxysilane (110 g) were added, and the resulting mixture was stirred at 50°C. To this, potassium hydroxide (0.6 g)/water (114 g) were added dropwise slowly, and the resulting mixture was stirred at 50°C for 6 hours after the completion of adding dropwise. To this, acetic acid (0.7 g) was added, and volatile components were removed under a reduced pressure and potassium acetate was filtered out to obtain a polymer. The obtained polymer was washed with hexane/water and volatile components were removed under a reduced pressure to obtain a polymer 1. The polymer I had a molecular weight Mn of 2000 and a molecular weight Mw of 4600, and the formula of the polymer I was

(Me₂SiO_{2/2})_{0.65}(MeCHSiO_{2/2})_{0.20}(EpSiO_{3/2})₀.₁₅

from 29Si NMR analysis, and the content of a 2-(3,4-epoxycyclohexyl)ethyl group was 19 mol% and epoxy equivalent was 690 g/eq. The content of the alkoxy group was 2 mol%.
Here, the molecular weight and the epoxy equivalent of the polymer I, and the content of an alkoxy group were determined in the same manner as in Synthetic Example 1.

### (Synthetic Example 10)

To a 2000 milliliter separable flask equipped with a thermometer and a dropping apparatus, dimethyldimethoxysilane (480 g), methyltrimethoxysilane (100 g) and 2-(3,4-epoxycyclohexyl)ethyl-trimethoxysilane (20 g) were added, and the resulting mixture was stirred at 50°C. To this, potassium hydroxide (1.3 g)/water (187 g) were added dropwise slowly, and the resulting mixture was stirred at 50°C for 6 hours after the completion of adding dropwise. To this, acetic acid (1.4 g) was added, and volatile components were removed under a reduced pressure and potassium acetate was filtered out to obtain a polymer. The obtained polymer was washed with hexane/water and volatile components were removed under a reduced pressure to obtain a polymer J. The polymer J had a molecular weight Mn of 2100 and a molecular weight Mw of 4700, and the formula of the polymer J was

(Me₂SiO_{2/2})_{0.83}(MeSiO_{3/2})_{0.15}(EpSiO_{3/2})_{0.02}

from 29Si NMR analysis, and the content of a 2-(3,4-epoxycyclohexyl)ethyl group was 3 mol% and epoxy equivalent was 4820 g/eq. The content of the alkoxy group was 4 mol%.
Here, the molecular weight and the epoxy equivalent of the polymer J, and the content of an alkoxy group were determined in the same manner as in Synthetic Example 1.

### (Synthetic Example 11)

To a 2000 milliliter separable flask equipped with a thermometer and a dropping apparatus, dimethyldimethoxysilane (500 g), 3-glycidoxypropyl (methyl)dimethoxysilane (80 g) and methyltrimethoxysilane (20 g) were added, and the resulting mixture was stirred at 50°C. To this, potassium hydroxide (1.3 g) /water (170 g) were added dropwise slowly, and the resulting mixture was stirred at 50°C for 6 hours after the completion of adding dropwise. To this, acetic acid (1.4 g) was added, and volatile components were removed under a reduced pressure and potassium acetate was filtered out to obtain a polymer. The obtained polymer was washed with hexane/water and volatile components were removed under a reduced pressure to obtain a polymer K. The polymer K had a molecular weight Mn of 2700 and a molecular weight Mw of 6300, and the formula of the polymer K was

(Me₂SiO_{2/2})_{0.89}(EpSiO_{2/2})_{0.08}(MeSiO_{3/2})_{0.03}

from 29Si NMR analysis, and the content of a 3-glycidoxypropyl group was 11 mol% and epoxy equivalent was 950 g/eq. The content of the alkoxy group was 1.5 mol%.
Here, the molecular weight and the epoxy equivalent of the polymer K, and the content of an alkoxy group were determined in the same manner as in Synthetic Example 1.

### (Synthetic Example 12)

To a 2000 milliliter separable flask equipped with a thermometer and a dropping apparatus, dimethyldimethoxysilane (275 g), methyltrimethoxysilane (200 g) and 2-(3,4-epoxycyclohexyl)ethyl-trimethoxysilane (125 g) were added, and the resulting mixture was stirred at 50°C. To this, potassium hydroxide (1.2 g) /water (189 g) were added dropwise slowly, and the resulting mixture was stirred at 50°C for 6 hours after the completion of adding dropwise. To this, acetic acid (1.3 g) was added, and volatile components were removed under a reduced pressure and potassium acetate was filtered out to obtain a polymer. The obtained polymer was washed with hexane/water and volatile components were removed under a reduced pressure to obtain a polymer L. The polymer L had a molecular weight Mn of 1800 and a molecular weight Mw of 4000, and the formula of the polymer L was

(Me₂SiO_{2/2})_{0.54}(MeSiO_{3/2})_{0.34}(EpSiO_{3/2})_{0.12}

from 29Si NMR analysis, and the content of a 2-(3,4-epoxycyclohexyl)ethyl group was 18 mol% and epoxy equivalent was 690 g/eq. The content of the alkoxy group was 4 mol%.
Here, the molecular weight and the epoxy equivalent of the polymer L, and the content of an alkoxy group were determined in the same manner as in Synthetic Example 1.

### (Synthetic Example 13)

To a 2000 milliliter separable flask equipped with a thermometer and a dropping apparatus, dimethyldimethoxysilane (125 g), 3-glycidoxypropyl (methyl) dimethoxysilane (375 g) and methyltrimethoxysilane (100 g) were added, and the resulting mixture was stirred at 50°C. To this, potassium hydroxide (1.0 g) /water (138 g) were added dropwise slowly, and the resulting mixture was stirred at 50°C for 6 hours after the completion of adding dropwise. To this, acetic acid (1.1 g) was added, and volatile components were removed under a reduced pressure and potassium acetate was filtered out to obtain a polymer. The obtained polymer was washed with hexane/water and volatile components were removed under a reduced pressure to obtain a polymer M. The polymer M had a molecular weight Mn of 2700 and a molecular weight Mw of 8200, and the formula of the polymer M was

(Me₂SiO_{2/2})_{0.30}(EpSiO_{2/2})_{0.48}(MeSiO_{3/2})_{0.22}

from 29Si NMR analysis, and the content of a 3-glycidoxypropyl group was 46 mol% and epoxy equivalent was 220 g/eq. The content of the alkoxy group was 2 mol%.
Here, the molecular weight and the epoxy equivalent of the polymer M, and the content of an alkoxy group were determined in the same manner as in Synthetic Example 1.

### (Example 1)

The polymer B (100 g), RIKACID MH-700G (acid anhydride, produced by New Japan Chemical Co., Ltd., 10 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 2)

The polymer C (100 g), RIKACID MH-700G (acid anhydride, produced by New Japan Chemical Co., Ltd., 25 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 3)

The polymer D (100 g), RIKACID MH-700G (acid anhydride, produced by New Japan Chemical Co., Ltd., 25 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 4)

The polymer E (100 g), RIKACID MH-700G (acid anhydride, produced by New Japan Chemical Co., Ltd., 15 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 5)

The polymer F (100 g), RIKACID MH-700G (acid anhydride, produced by New Japan Chemical Co., Ltd., 20 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 6)

The polymer G (100 g), RIKACID MH-700G (acid anhydride, produced by New Japan Chemical Co., Ltd., 40 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 7)

The polymer H (100 g), RIKACID MH-700G (acid anhydride, produced by New Japan Chemical Co., Ltd., 25 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 8)

The polymer I (100 g), RIKACID MH-700G (acid anhydride, produced by New Japan Chemical Co., Ltd., 20 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 9)

The polymer D (70 g), the polymer A (30 g), RIKACID MH-700G (acid anhydride, produced by New Japan Chemical Co., Ltd., 20 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 10)

The polymer F (70 g), the polymer A (30 g), RIKACID MH-700G (acid anhydride, produced by New Japan Chemical Co., Ltd., 15 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 11)

The polymer D (100 g), RIKACID MH-700G (acid anhydride, produced by New Japan Chemical Co., Ltd., 25 g), U-CAT SA 102 (curing accelerator, produced by SAN-APRO Ltd., 0.5 g), and AEROSILRX200 (fine powder silica (treated with trimethylsilyl, specific surface area: 140 m²/g), produced by Nippon Aerosil Co., Ltd., 10 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 12)

The polymer D (100 g), RIKACID MH-700G (acid anhydride, produced by New Japan Chemical Co., Ltd., 25 g), U-CAT SA 102 (curing accelerator, produced by SAN-APRO Ltd., 0.5 g), and AEROSIL R8200 (fine powder silica (treated with trimethylsilyl, specific surface area: 160 m²/g), produced by Nippon Aerosil Co., Ltd., 20 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 13)

The polymer D (100 g), RIKACID MH-700G (acid anhydride, produced by New Japan Chemical Co., Ltd., 25 g), U-CAT SA 102 (curing accelerator, produced by SAN-APRO Ltd., 0.5 g), and AEROSIL R974 (fine powder silica (treated with dimethylsilyl, specific surface area: 140 m²/g), produced by Nippon Aerosil Co., Ltd., 10 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 14)

The polymer D (100 g), RIKACID MH-700G (acid anhydride, produced by New Japan Chemical Co., Ltd., 25 g), U-CAT SA 102 (curing accelerator, produced by SAN-APRO Ltd., 0.5 g), and AEROSIL R805 (fine powder silica (treated with octylsilyl, specific surface area: 140 m²/g), produced by Nippon Aerosil Co., Ltd., 10 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 15)

The polymer E (100 g), RIKACID MH-700G (acid anhydride, produced by New Japan Chemical Co., Ltd., 15 g), U-CAT SA 102 (curing accelerator, produced by SAN-APRO Ltd., 0.5 g), and AEROSIL RX200 (fine powder silica (treated with trimethylsilyl, specific surface area: 140 m²/g), produced by Nippon Aerosil Co., Ltd., 10 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 16)

The polymer F (100 g), RIKACID MH-700G (acid anhydride, produced by New Japan Chemical Co., Ltd., 20 g), U-CAT SA 102 (curing accelerator, produced by SAN-APRO Ltd., 0.5 g), and AEROSIL RX200 (fine powder silica (treated with trimethylsilyl, specific surface area: 140 m²/g), produced by Nippon Aerosil Co., Ltd., 10 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 17)

The polymer D (70 g), the polymer A (30 g), RIKACID MH-700G (acid anhydride, produced by New Japan Chemical Co., Ltd., 20 g), U-CAT SA 102 (curing accelerator, produced by SAN-APRO Ltd., 0.5 g), and AEROSIL R8200 (fine powder silica (treated with trimethylsilyl, specific surface area: 160 m²/g), produced by Nippon Aerosil Co., Ltd., 20 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Example 18)

The polymer F (70 g), the polymer A (30 g), RIKACID MH-700G (acid anhydride, produced by New Japan Chemical Co., Ltd., 15 g), U-CAT SA 102 (curing accelerator, produced by SAN-APRO Ltd., 0.5 g), and AEROSIL R8200 (fine powder silica (treated with trimethylsilyl, specific surface area: 160 m²/g), produced by Nippon Aerosil Co., Ltd., 20 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 1)

The polymer A (100 g), RIKACID MH-700G (acid anhydride, produced by New Japan Chemical Co., Ltd., 20 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 2)

The polymer J (100 g), RIKACID MH-700G (acid anhydride, produced by New Japan Chemical Co., Ltd., 5 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 3)

The polymer K (100 g), RIKACID MH-700G (acid anhydride, produced by New Japan Chemical Co., Ltd., 15 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 4)

The polymer L (100 g), RIKACID MH-700G (acid anhydride, produced by New Japan Chemical Co., Ltd., 20 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 5)

The polymer M (100 g), RIKACID MH-700G (acid anhydride, produced by New Japan Chemical Co., Ltd., 60 g), and U-CAT SA 102 (curing accelerator, produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 6)

CELLOXIDE 2021 (alicyclic epoxy resin, produced by DAICEL CHEMICAL INDUSTRIES, Ltd., 50 g), YX-8000 (hydrogenated bisphenol A epoxy resin, produced by Japan Epoxy Resins Co., Ltd., 50 g), RIKACID MH-700G (produced by New Japan Chemical Co., Ltd., 100 g), and U-CAT SA 102 (produced by SAN-APRO Ltd., 0.5 g) were mixed and defoamed to obtain a sealing agent for an optical semiconductor device. This sealing agent was filled into a mold and cured at 100°C for 3 hours and at 130°C for 3 hours to obtain a cured product with a thickness of 1 mm.

### (Comparative Example 7)

VDT-431 (polysiloxane having vinyl groups, produced by Gelest, Inc., 45 g), HMS-031 (organohydrogen polysiloxane, produced by Gelest, Inc., 55 g), and a solution of octyl alcohol modified chloroplatinic acid (Pt concentration 2% by weight, 0.05 g) were mixed and defoamed to obtain a sealing agent for an optical semiconductor device. This sealing agent was filled into a mold and cured at 100°C for 3 hours and at 150°C for 3 hours to obtain a cured product with a thickness of 1 mm.

### (Evaluation)

The following evaluations were performed on the sealing agents for an optical semiconductor device and cured product thereof prepared in Examples 1 to 18 and Comparative Examples 1 to 7. The results of the evaluations of Examples 1 to 12 are shown in Table 1 below and the results of the evaluations of Examples 13 to 18 and Comparative Examples 1 to 7 are shown in Table 2 below.

### (1) Initial light transmittance

The cured product with a thickness of 1 mm was used and its light transmittance at a wavelength of 400 nm was measured with U-4000 manufactured by Hitachi, Ltd.

### (2) Light transmittance after lightfastness test

Light from a high-pressure mercury lamp equipped with a filter to cut off light with a wavelength of 340 nm or less was irradiated to the cured product with a thickness of 1 mm at 100 mW/cm² for 24 hours, and then the light transmittance of the cured product at a wavelength of 400 nm was measured with U-4000 manufactured by Hitachi, Ltd.
Here, in Table 1 and Table 2, the cured product whose rate of decrease of the light transmittance from the initial light transmittance is less than 5% was expressed by ⊚, the cured product whose rate of decrease is less than 10% was expressed by ○, the cured product whose rate of decrease is at least 10% and less than 40% was expressed by Δ, and the cured product whose rate of decrease is at least 40% was expressed by ×.

### (3) Light transmittance after heat resistance test

The cured product with a thickness of 1 mm was left standing in an oven of 150°C for 1000 hours and its light transmittance at a wavelength of 400 nm was measured with U-4000 manufactured by Hitachi, Ltd.
Here, in Table 1 and Table 2, the cured product whose rate of decrease of the light transmittance from the initial light transmittance is less than 5% was expressed by ⊚, the cured product whose rate of decrease is less than 10% was expressed by ○, the cured product whose rate of decrease is at least 10% and less than 40% was expressed by Δ, and the cured product whose rate of decrease is at least 40% was expressed by ×.

### (4) Adhesion test

Each of the sealing agents for an optical semiconductor device prepared in Examples and Comparative Examples was applied to aluminum, polyphthalamide (PPA) resin, or polybutylene terephthalate (PBT) resin, and the sealing agent was cured at 100°C for 3 hours and at 130°C for 3 hours to prepare a thin film, and slits of 1 mm pitch were cut on the film to form 100 lattices, and an adhesion test of the thin film was performed by a cross-cut test with a sellotape according to JIS K-5400.
Here, in Table 1 and Table 2, the cured product in which number of cross cuts peeled off was zero was expressed by ○, the cured product in which number of cross cuts peeled off was 1 to 70 was expressed by Δ, and the cured product in which number of cross cuts peeled off was 71 to 100 was expressed by ×.

### (5) Decrease rate in thickness after heat resistance test

The cured product with a thickness of 1 mm was left standing in an oven of 150°C for 1000 hours, and its decrease rate in thickness was observed based on a change in thickness of the cured product. The results are determined according to the following criteria.
Here, in Table 1 and Table 2, the cured product in which there was little decrease in thickness (change in thickness is less than 1%) was expressed by ⊚, the cured product in which there was a slight decrease in thickness (change in thickness is less than 3%) was expressed by ○, the cured product in which there was a little decrease in thickness (change in thickness is less than 10%) was expressed by Δ, and the cured product in which there was a remarkable decrease in thickness (change in thickness is 10% or more) was expressed by ×.

**[Table 1]**

| | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| Initial light transmittance | | 90 | 90 | 90 | 90 | 90 | 90 | 90 | 90 | 90 | 90 | 90 | 90 |
| Heat resistance | | ⊚ | ○ | ⊚ | ○ | ⊚ | ○ | ○ | ⊚ | ⊚ | ⊚ | ⊚ | ⊚ |
| Lightfastness | | ⊚ | ⊚ | ⊚ | ⊚ | ⊚ | ○ | ⊚ | ⊚ | ⊚ | ⊚ | ⊚ | ⊚ |
| Adhesion | PPA | ○ | ○ | ○ | ○ | ○ | ○ | ○ | ○ | ○ | ○ | ○ | ○ |
| | PBT | ○ | ○ | ○ | ○ | ○ | ○ | ○ | ○ | ○ | ○ | ○ | ○ |
| | Aluminum | ○ | ○ | ○ | ○ | ○ | ○ | ○ | ○ | ○ | ○ | ○ | ○ |
| Decrease in thickness | | ○ | ⊚ | ⊚ | ⊚ | ⊚ | ⊚ | ⊚ | ⊚ | ⊚ | ⊚ | ⊚ | ⊚ |

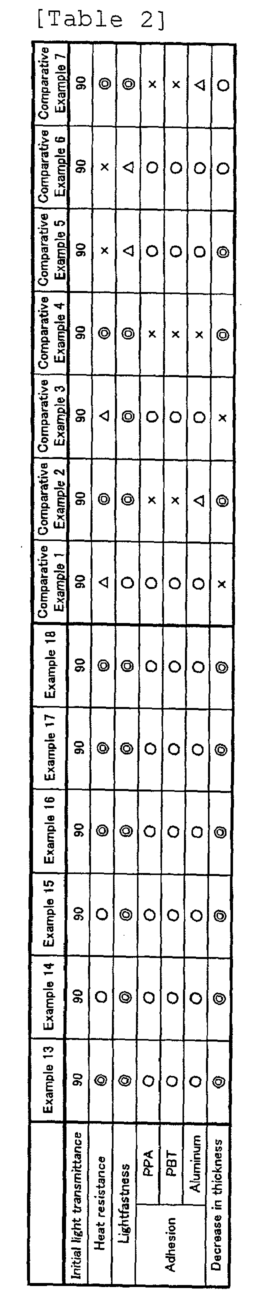

Next, each of the sealing agents for an optical semiconductor device prepared in Examples 3 to 5 and 9 to 18 was used, and its moisture absorption reflow test and cold-hot cycle test were performed according the following methods. The results of the tests are shown in Table 3.

### (Preparation of die bond material for optical semiconductor device)

Silver powder (170 g) in flake form, having an average particle diameter of 3 µm and a maximum particle diameter of 20 µm, was added to the polymer D (30 g) and the resulting mixture was stirred and kneaded with a three roll. To the polymer containing silver powder in flake form (100 g), RIKACID MH-700G (acid anhydride, produced by New Japan Chemical Co., Ltd., 3.75 g) and U-CAT SA 102 (produced by SAN-APRO Ltd., 0.075 g) were added, and the resulting mixture was mixed and defoamed to obtain a die bond material for optical semiconductor device.

### (Preparation of optical semiconductor device)

A light emitting device having a main luminous peak of 460 nm was mounted on a housing material (PPA) with a lead electrode using the prepared die bond material for optical semiconductor device, and this die bond material was cured at 180°C for 15 minutes to secure the light emitting device. Subsequently, the light emitting device is electrically connected to the lead electrode with a gold wire, and each of the sealing agents for an optical semiconductor device prepared in Examples 3 to 5 and 9 to 18 was filled and cured at 100°C for 3 hours and at 130°C for 3 hours to prepare an optical semiconductor device of a structure shown in Fig. 2.

### (Moisture absorption reflow test, cold-hot cycle test)

Each of the prepared optical semiconductor devices (20 pieces) was left standing for 24 hours in an environment of 85°C and 85% in relative humidity, and the optical semiconductor device having absorbed moisture was passed through a solder reflow oven (preheating at 150°C for 100 seconds and reflowing (maximum temperature 260°C)) three times, and then number of the optical semiconductor devices in which cracks were produced or peeling off from the housing material occurred was counted (moisture absorption reflow test). The results are shown in Table 3.
Furthermore, the optical semiconductor devices (20 pieces) subjected to the moisture absorption reflow test were subjected to a cold-hot cycle of 30 minutes at -40°C and 30 minutes at 120°C and this cycle was repeated 100 times, 300 times and 1000 times, and number of the optical semiconductor devices in which cracks were produced or peeling off from the housing material occurred was counted (cold-hot cycle test). The results are shown in Table 3.

**[Table 3]**

| | | | Example 3 | Example 4 | Example 5 | Example 9 | Example 10 | Example 11 | Example 12 | Example 13 | Example 14 | Example 15 | Example 16 | Example 17 | Example 18 |
|---|---|---|---|---|---|---|---|---|---|---|---|---|---|---|---|
| Moisture absorption reflow test | | Number of optical semiconductor devices in which cracks were produced | 0/20 | 0/20 | 0/20 | 0/20 | 0/20 | 0/20 | 0/20 | 0/20 | 0/20 | 0/20 | 0/20 | 0/20 | 0/20 |
| | | Number of optical semiconductor devices in which peeling off occurred | 0/20 | 0/20 | 0/20 | 0/20 | 0/20 | 0/20 | 0/20 | 0/20 | 0/20 | 0/20 | 0/20 | 0/20 | 0/20 |
| Cool -hot cycle test | 100 times | Number of optical semiconductor devices in which cracks were produced | 0/20 | 0/20 | 0/20 | 0/20 | 0/20 | 0/20 | 0/20 | 0/20 | 0/20 | 0/20 | 0/20 | 0/20 | 0/20 |
| | | Number of optical semiconductor devices in which peeling off occurred | 0/20 | 0/20 | 0/20 | 0/20 | 0/20 | 0/20 | 0/20 | 0/20 | 0/20 | 0/20 | 0/20 | 0/20 | 0/20 |
| | 300 times | Number of optical semiconductor devices in which cracks were produced | 0/20 | 2/20 | 5/20 | 0/20 | 0/20 | 0/20 | 0/20 | 0/20 | 0/20 | 0/20 | 0/20 | 0/20 | 0/20 |
| | | Number of optical semiconductor devices in which peeling off occurred | 0/20 | 0/20 | 0/20 | 0/20 | 0/20 | 0/20 | 0/20 | 0/20 | 0/20 | 0/20 | 0/20 | 0/20 | 0/20 |
| | 1000 times | Number of optical semiconductor devices in which cracks were produced | 12/20 | 15/20 | 18/20 | 0/20 | 0/20 | 0/20 | 0/20 | 0/20 | 0/20 | 2/20 | 4/20 | 0/20 | 0/20 |
| | | Number of optical semiconductor devices in which peeling off occurred | 0/20 | 0/20 | 0/20 | 0/20 | 0/20 | 0/20 | 0/20 | 0/20 | 0/20 | 0/20 | 0/20 | 0/20 | 0/20 |

### INDUSTRIAL APPLICABILITY

In accordance with the present invention, it is possible to provide a thermosetting composition for an optical semiconductor which is highly transparent, is free-from decrease in thickness or discoloration of a cured product due to heat generation or light emitting of a light emitting device, is superior in heat resistance and lightfastness, and has excellent adhesion to a housing material or the like, a sealing agent for an optical semiconductor device and a die bond material for an optical semiconductor device using the same, and an optical semiconductor device obtained by using the thermosetting composition for an optical semiconductor, the sealing agent for an optical semiconductor, the die bond material for an optical semiconductor device and/or the underfill material for an optical semiconductor device.

### BRIEF DESCRIPTIONS OF THE DRAWINGS

[Fig. 1] Fig. 1 is a sectional view schematically showing an example of an optical semiconductor device obtained by using a sealing agent for an optical semiconductor and a die bond material for an optical semiconductor device of the present invention.
[Fig. 2] Fig. 2 is a sectional view schematically showing an example of an optical semiconductor device obtained by using a sealing agent for an optical semiconductor and a die bond material for an optical semiconductor device of the present invention.
[Fig. 3] Fig. 3 is a sectional view schematically showing an example of an optical semiconductor device obtained by using a sealing agent for an optical semiconductor and an underfill material for an optical semiconductor device of the present invention.
[Figs. 4] Fig. 4(a) is a sectional view schematically showing a condition in which an alkyl group-containing silane type compound having a structure expressed by the formula (16) is coupled with the surface of a silicon oxide fine particle.
[Figs. 4] Fig. 4(b) is a sectional view schematically showing a condition in which an alkyl group-containing silane type compound having a structure expressed by the formula (17) is coupled with the surface of a silicon oxide fine particle.
[Figs. 4] Fig. 4(c) is a sectional view schematically showing a condition in which an alkyl group-containing silane type compound having a structure expressed by the formula (18) is coupled with the surface of a silicon oxide fine particle.

### EXPLANATION OF SYMBOLS

10, 20 die bond material for an optical semiconductor device
11, 21, 31 light emitting device
12, 22, 32 sealing agent for an optical semiconductor
13, 23 gold wire
14, 24, 34 lead electrode
15, 25, 35 housing material
16 heat sink
30 underfill material for an optical semiconductor
33 bump
40 silicon oxide fine particle
41, 42, 43 organic silicon type compound

## Claims

1. A thermosetting composition for an optical semiconductor,
which contains a silicone resin having a cyclic ether-containing group and a thermosetting agent capable of reacting with said cyclic ether-containing group,
wherein said silicone resin has, as the principal components, a structural unit expressed by the following formula (1) and a structural unit expressed by the following formula (2), the content of the structural unit expressed by said formula (1) is 0.6 to 0.95 (on a molar basis) and the content of the structural unit expressed by said formula (2) is 0.05 to 0.4 (on a molar basis) when total number of the structural units contained is taken as 1, and the content of said cyclic ether-containing group is 5 to 40 mol%:
[formula 1] (R¹R²SiO_{2/2}) (1)
and
[formula 2] (R³SiO_{3/2}) (2)
in the formulas (1) and (2), at least one of R¹, R² and R³ represents a cyclic ether-containing group, R¹, R² and R³ other than said cyclic ether-containing group represent hydrocarbon having 1 to 8 carbon atoms or fluoride thereof and they may be the same or may be different from one another and plural types of R¹, R² and R³ different from each other in a repeating unit in a silicone resin skeleton may be contained.

2. The thermosetting composition for an optical semiconductor according to claim 1,
wherein the cyclic ether-containing group in the silicone resin is coupled with a polysiloxane skeleton via a silicon-carbon bond.

3. The thermosetting composition for an optical semiconductor according to claim 1 or 2,
wherein the silicone resin has a cyclic ether-containing group in the structural unit expressed by the formula (2).

4. The thermosetting composition for an optical semiconductor according to claim 1, 2 or 3,
wherein the silicone resin contains an alkoxy group in an amount of 0.5 to 10 mol%.

5. The thermosetting composition for an optical semiconductor according to claim 1, 2, 3 or 4,
wherein the cyclic ether-containing group is an epoxycyclohexyl group.

6. The thermosetting composition for an optical semiconductor according to claim 1, 2, 3, 4 or 5,
wherein the number average molecular weight of the silicone resin is 1000 to 50000.

7. The thermosetting composition for an optical semiconductor according to claim 1, 2, 3, 4, 5 or 6,
which further contains a bifunctional silicone resin whose average composition formula is expressed by the following formula (15):
[formula 3] (R³⁷R³⁸SiO_{2/2})ᵣ(R³⁹R⁴⁰SiO_{2/2})ₛ (15)
in the formula (15), r satisfies the equations r/ (r+s)=0.6 to 0.95 and s/ (r+s)=0.05 to 0.4, R³⁹ and/or R⁴⁰ is a glycidyl-containing group, R³⁷ and R³⁸ represent hydrocarbon having 1 to 8 carbon atoms or fluoride thereof, and they may be the same or may be different from one another, and when only one of R³⁹ and R⁴⁰ is a glycidyl-containing group, the other represents hydrocarbon having 1 to 8 carbon atoms or fluoride thereof,
or the following formula (16):
[formula 4] (R⁴¹R⁴²SiO_{2/2})ₜ(R⁴³R⁴⁴SiO_{2/2})ᵤ(R⁴⁵R⁴⁶SiO_{2/2})ᵥ (16)
in the formula (16), t, u and v satisfy the equations t+u/(t+u+v)=0.6 to 0.95 and v/ (t+u+v)=0.05 to 0.4, R⁴⁵ and/or R⁴⁶ is a glycidyl-containing group, R⁴¹, R⁴², R⁴³ and R⁴⁴ represent hydrocarbon having 1 to 8 carbon atoms or fluoride thereof, and they may be the same or may be different from one another, and when only one of R⁴⁵ and R⁴⁶ is a glycidyl-containing group, the other represents hydrocarbon having 1 to 8 carbon atoms or fluoride thereof.

8. The thermosetting composition for an optical semiconductor according to claim 1, 2, 3, 4, 5, 6 or 7,
wherein the thermosetting agent is an acid anhydride.

9. The thermosetting composition for an optical semiconductor according to claim 1, 2, 3, 4, 5, 6, 7 or 8,
which further contains a silicon oxide fine particle surface-treated with an organic silicon type compound.

10. The thermosetting composition for an optical semiconductor according to claim 9,
wherein a BET specific surface area of the silicon oxide fine particle surface-treated with the organic silicon type compound is 30 to 400 m²/g.

11. The thermosetting composition for an optical semiconductor according to claim 9 or 10,
wherein the organic silicon type compound is an alkyl group-containing silane type compound having a structure expressed by the following formula (17), (18) or (19): 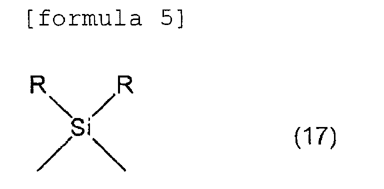 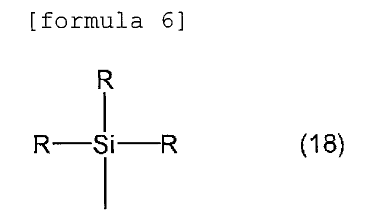 and 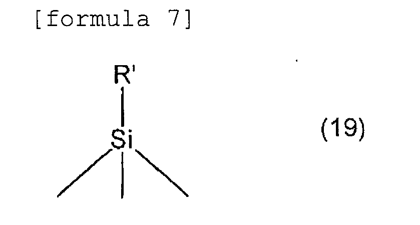 in the formula (17) and (18), R represents an alkyl group having 1 to 3 carbon atoms and in the formula (19), R' represents an alkyl group having 4 to 8 carbon atoms.

12. The thermosetting composition for an optical semiconductor according to claim 9, 10 or 11,
wherein the organic silicon type compound is a compound having a dimethylsilyl group or a trimethylsilyl group.

13. The thermosetting composition for an optical semiconductor according to claim 1, 2, 3, 4, 5, 6, 7, 8, 9, 10, 11 or 12,
which further contains a fine particle having a metal element.

14. The thermosetting composition for an optical semiconductor according to claim 13,
wherein an average primary particle diameter of the fine particle having a metal element is 20 nm or less.

15. The thermosetting composition for an optical semiconductor according to claim 13 or 14,
wherein 80% or more of metal elements existing in the fine particle are at least one kind of metal element selected from the group consisting of Al, In, Ge, Sn, Ti, Zr and Hf.

16. A sealing agent for an optical semiconductor device,
which is obtained by using the thermosetting composition for an optical semiconductor according to claim 1, 2, 3, 4, 5, 6, 7, 8, 9, 10, 11, 12, 13, 14 or 15.

17. A die bond material for an optical semiconductor device,
which is obtained by using the thermosetting composition for an optical semiconductor according to claim 1, 2, 3, 4, 5, 6, 7, 8, 9, 10, 11, 12, 13, 14 or 15.

18. The die bond material for an optical semiconductor device according to claim 17,
which further contains highly thermally-conductive fine particles.

19. An underfill material for an optical semiconductor device,
which is obtained by using the thermosetting composition for an optical semiconductor according to claim 1, 2, 3, 4, 5, 6, 7, 8, 9, 10, 11, 12, 13, 14 or 15.

20. An optical semiconductor device,
which is obtained by using the thermosetting composition for an optical semiconductor according to claim 1, 2, 3, 4, 5, 6, 7, 8, 9, 10, 11, 12, 13, 14 or 15, the sealing agent for an optical semiconductor device according to claim 16, the die bond material for an optical semiconductor device according to claim 17 or 18 and/or the underfill material for an optical semiconductor device according to claim 19.
